(19) **Europäisches Patentamt / European Patent Office / Office européen des brevets**

(11) **EP 3 877 912 B1**

(12) # FASCICULE DE BREVET EUROPEEN

(45) Date de publication et mention de la délivrance du brevet:
**01.04.2026 Bulletin 2026/14**

(21) Numéro de dépôt: **19817401.3**

(22) Date de dépôt: **07.11.2019**

(51) Classification Internationale des Brevets (IPC):
**G06N 3/082** *(2023.01)*  **G06N 3/084** *(2023.01)*
**G06N 5/01** *(2023.01)*  **G06N 3/0495** *(2023.01)*
**G06N 3/0499** *(2023.01)*  **G06N 3/0455** *(2023.01)*
**G06N 3/0985** *(2023.01)*

(52) Classification Coopérative des Brevets (CPC):
**G06N 3/0455; G06N 3/0495; G06N 3/0499;
G06N 3/082; G06N 3/084; G06N 3/0985;
G06N 5/01**

(86) Numéro de dépôt international:
**PCT/FR2019/052649**

(87) Numéro de publication internationale:
**WO 2020/094995 (14.05.2020 Gazette 2020/20)**

(54) **PROCÉDÉ DE CONSTRUCTION DE RÉSEAU DE NEURONES**

VERFAHREN ZUR NEURONALEN NETZWERKKONSTRUKTION

METHOD OF NEURAL NETWORK CONSTRUCTION

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **09.11.2018 FR 1860383
23.01.2019 FR 1900572**

(43) Date de publication de la demande:
**15.09.2021 Bulletin 2021/37**

(73) Titulaire: **Adagos
31520 Ramonville-Saint-Agne (FR)**

(72) Inventeurs:
- **BOMPARD, Manuel**
  **31520 RAMONVILLE (FR)**
- **CAUSSE, Mathieu**
  **31520 RAMONVILLE (FR)**
- **MASMOUDI, Florent**
  **31520 RAMONVILLE (FR)**
- **MASMOUDI, Mohamed**
  **31520 RAMONVILLE (FR)**
- **TURKI, Houcine**
  **31520 RAMONVILLE (FR)**

(74) Mandataire: **Plasseraud IP
104 Rue de Richelieu
CS92104
75080 Paris Cedex 02 (FR)**

(56) Documents cités:
  US-A- 5 636 326     US-A1- 2018 322 388
  US-B1- 9 336 483

- **HONGLEI ZHANG ET AL: "Finding Better Topologies for Deep Convolutional Neural Networks by Evolution", ARXIV.ORG, CORNELL UNIVERSITY LIBRARY, 201 OLIN LIBRARY CORNELL UNIVERSITY ITHACA, NY 14853, 10 September 2018 (2018-09-10), XP081189221**
- **ANONYMOUS: "ADAGOS", 20 September 2018 (2018-09-20), XP055657427, Retrieved from the Internet <URL:https://web.archive.org/web/20180920073216/https://www.adagos.com/> [retrieved on 20200113]**
- **GAO HUANG ET AL: "Orthogonal Least Squares Algorithm for Training Cascade Neural Networks", IEEE TRANSACTIONS ON CIRCUITS AND SYSTEMS I: REGULAR PAPERS, IEEE, US, vol. 59, no. 11, 1 November 2012 (2012-11-01), pages 2629 - 2637, XP011470702, ISSN: 1549-8328, DOI: 10.1109/TCSI.2012.2189060**

## Description

### Domaine technique

L'invention concerne l'apprentissage de phénomènes représentant des systèmes réels avec des réseaux neuronaux parcimonieux, ayant très peu de connexions.

L'invention s'applique notamment à la simulation d'un système réel statique, par exemple pour évaluer la réponse du système réel dans de nouvelles situations, mais également à la simulation d'un système réel dynamique sur des temps longs, par exemple pour modéliser l'évolution d'un système réel. Le modèle dynamique est basé sur une forme récurrente d'un réseau de neurones à propagation avant que nous appellerons dans ce qui suit « motif récurrent ».

L'invention trouve une application avantageuse dans la simulation au moins temps réel de systèmes physiques complexes.

### Technique antérieure

La présente invention propose une méthode d'apprentissage de phénomènes réels par des réseaux neuronaux parcimonieux, ayant très peu de connexions. Cela peut concerner des phénomènes physiques, biologiques, chimiques ou encore informatiques.

Les méthodes de l'état de l'art se sont largement inspirées du cerveau biologique qui est fortement redondant. La redondance permet de protéger le cerveau contre la perte de cellules neuronales. Cette perte peut être accidentelle ou non. Il se trouve que le choix redondant, dans les réseaux neuronaux artificiels, joue un rôle majeur dans le processus d'apprentissage.

La première cause de la redondance est liée à l'organisation de la topologie du réseau neuronal par couches de cellules neuronales. Il appartient à l'utilisateur de définir le nombre de couches et le nombre de cellules par couche... Cette construction se fait d'une manière manuelle selon un processus d'essai sur erreur. Le réseau neuronal doit avoir une taille suffisante pour effectuer l'apprentissage, mais sa taille n'est pas minimale et elle est forcément redondante.

Ce caractère redondant joue un rôle majeur dans le processus d'apprentissage. En effet, d'après la publication de LeCun, Yann; Bengio, Yoshua; Hinton, Geoffrey (2015). "Deep learning". Nature. 521 (7553): 436-444, le processus d'apprentissage n'est pas piégé par les minima locaux, lorsque le réseau neuronal a une taille suffisante.

Cette propriété fondamentale, fait de la méthode du gradient un candidat possible pour assurer l'apprentissage. Mais cette méthode, réputée pour avoir un taux de convergence très faible (https://en.wikipedia.org/wiki/Gradient_des cent), assure une très bonne descente de l'erreur au début du processus d'apprentissage. D'où l'idée du gradient stochastique : Bottou, L. (2010). Large-scale machine learning with stochastic gradient descent. In Proceedings of COMPSTAT'2010 (pp. 177-186). Physica-Verlag HD, qui renforce cette propriété en changeant de fonction d'erreur à chaque itération du gradient. Cela consiste à appliquer une itération du gradient à chaque échantillon d'apprentissage à tour de rôle. Parfois, la méthode du gradient stochastique est appliquée par petits groupes d'échantillons. Le gradient stochastique, comme le gradient, n'a pas de bonne convergence locale. La réponse à ce problème est la redondance. En effet, en raison de ce caractère redondant, il faut que le processus d'apprentissage s'arrête prématurément pour éviter le phénomène de surapprentissage. Ainsi les méthodes du gradient et du gradient stochastique ne sont utilisées que dans leur domaine d'efficacité.

Enfin, dans un contexte redondant, le grand nombre de poids de connexions à déterminer nécessite l'utilisation de quantités massives de données. L'état de l'art va de pair avec ce que l'on appelle en anglais « big data ».

L'état de l'art représente un édifice cohérent basé sur la redondance. Mais l'absence de convergence locale montre que l'état de l'art est orienté vers l'apprentissage qualitatif. Si la réponse est supérieure à 0,5, on l'assimile à un et si elle est inférieure à 0,5, on l'assimile à 0. Les réponses quantitatives ont des exigences de précision qui ne sont pas prises en compte par ces méthodes.

La présente invention répond aux besoins du domaine émergeant de la modélisation de systèmes physiques complexes par la création d'une copie numérique, également appelée jumeau numérique ou Digital Twin, du système physique, adaptée pour prédire avec fidélité l'état d'un système physique plus rapidement que le système réel, et de préférence des milliers de fois plus rapidement, de manière à être en mesure de simuler un grand nombre de scenarios possibles impactant le système physique avant de prendre la meilleure décision pour le système réel.

La notion de jumeau numérique a été introduite dans les publications suivantes :

- Glaessgen, E.H. & Stargel, D (Avril 2012), « The Digital Twin paradigm for future NASA and US Air Force vehicles », In 53rd Struct. Dyn. Mater. Conf. Special Session : Digital Twin, Honolulu, Hi, US.
- Tuegel, E.J., Ingraffea, A.R., Eason, T.G. & Spottswood, S.M. (2011), « Reengineering aircraft structural life prediction using a digital twin", International Journal of Aerospace Engineering, 2011.

La plupart des méthodes d'apprentissage, lorsqu'elles sont appliquées à des phénomènes quantitatifs, se limitent en général à des cas relativement simples qui ne nécessitent que des modèles peu profonds. En plus des méthodes neuronales, on peut citer des méthodes comme le Krigeage (en anglais « Kriging ») et la machine à support vectoriel (en anglais « Support Vector Machine Regression ») :

- Lophaven, S. N., Nielsen, H. B., & Søndergaard, J. (2002). DACE: a Matlab kriging toolbox (Vol. 2). IMM, Informatics and Mathematical Modelling, The Technical University of Denmark, :
- Balabin, R. M., & Lomakina, E. I. (2011). Support vector machine regression (SVR/LS-SVM)-an alternative to neural networks (ANN) for analytical chemistry? Comparison of nonlinear methods on near infrared (NIR) spectroscopy data. Analyst, 136(8), 1703-1712,

Ces deux méthodes, extrêmement populaires, peuvent être assimilées à des réseaux neuronaux peu profonds, n'ayant que trois couches de neurones.

Ces méthodes, ainsi que les réseaux neuronaux à faible nombre de couches couvrent l'essentiel des besoins dans le domaine de modélisation de phénomènes quantitatifs.

La nécessité de l'apprentissage profond et quantitatif apparait dans des cas particuliers tels que :

- La modélisation dynamique avec des réseaux neuronaux récurrents. Une prédiction sur 1000 pas de temps est équivalente à la création d'un réseau neuronal ayant plusieurs milliers de couches,
- La compression non linéaire de données par réseaux neuronaux, où le taux de compression augmente d'une manière considérable avec le nombre de couches du réseaux neuronaux.

Même si la détermination manuelle de la topologie du réseau neuronal domine l'état de l'art, la question de la détermination d'une topologie adaptée au problème est posée. La recherche automatique d'une topologie optimale est un vieux sujet de recherche dans le domaine neuronal. On peut citer par exemple Attik, M., Bougrain, L., & Alexandre, F. (2005, September). Neural network topology optimization. In International Conference on Artificial Neural Networks (pp. 53-58). Springer, Berlin, Heidelberg, qui est représentatif des techniques d'élagage (en anglais pruning) pour simplifier un réseau.

On peut citer d'autres méthodes d'optimisation topologique :

- Mineu, N. L., Ludermir, T. B., & Almeida, L. M. (2010, July). Topology optimization for artificial neural networks using differential evolution. In Neural Networks (IJCNN), The 2010 International Joint Conference on (pp. 1-7). IEEE.
- Nazghelichi, T., Aghbashlo, M., & Kianmehr, M. H. (2011). Optimization of an artificial neural network topology using coupled response surface methodology and genetic algorithm for fluidized bed drying. Computers and electronics in agriculture, 75(1), 84-91.

Elles sont basées sur les algorithmes génétiques. Ces méthodes sont connues pour être très lentes. Grâce aux moyens de calculs disponibles, ces méthodes sont de plus en plus utilisées, sur une base redondante des réseaux neuronaux.

Or, il existe aussi des applications pour lesquelles la quantité de données disponibles est très limitée (on parle alors de « small data »), et dans ce cas les structures redondantes de réseaux de neurones ne sont pas utilisables car elles exigent plus de données que ce qui est disponible.

D'autres approches consistent à créer un modèle réduit en s'appuyant sur des logiciels de simulation lourds, qui demandent des heures de calcul et qui ne sont pas compatibles avec le temps réel. Ces approches consistent à créer un espace de dimension réduite sur lequel sont projetés les paramètres du système. Ainsi par exemple, pour le cas d'un système dynamique, en notant $X_i$ la solution d'un problème non réduit à l'instant i, un solveur doit, pour déterminer $X_{i+1}$ à partir de $X_i$, résoudre un système de N équations de type $F(X_i, X_{i+1}) = 0$

Le nombre N est également la dimension des vecteurs $X_i$ et $X_{i+1}$. La mise en oeuvre d'un modèle réduit consiste à déterminer une base réduite orthonormée que l'on note $U=(U_1, U_2, ..., U_n)$ où n<<N. On peut donc comprimer $X_i$ par : $x_i = U^T X_i$, où les $x_i$ sont les coefficients de taille n de $X_i$, dans la base réduite U, et on peut décompresser $x_i$ pour obtenir $X_i$ comme suit : $X_i \approx U x_i$

Le modèle réduit consiste à résoudre à chaque pas de temps un système $F(Ux_i, Ux_{i+1})=0$ dont l'inconnue $x_{i+1}$ est de petite taille n. Ce système est résolu au sens des moindres carrés.

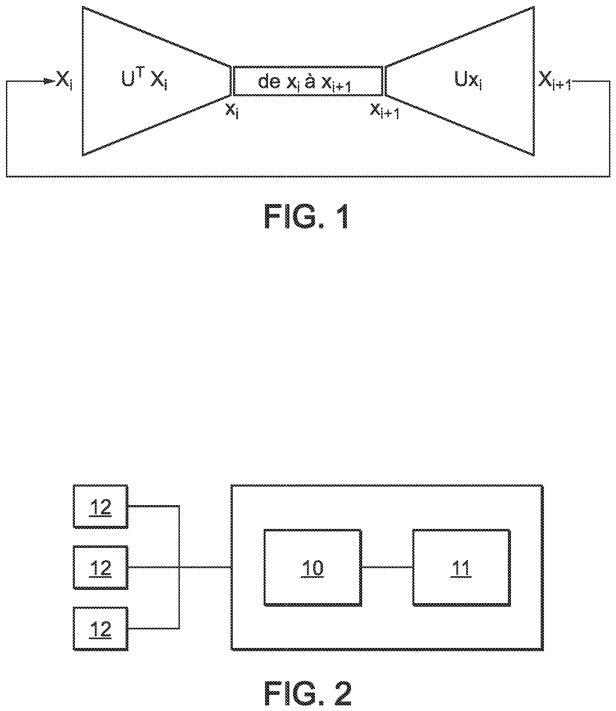

Comme représenté schématiquement sur la figure 1, une fois la donnée compressée $x_{i+1}$ déterminée à partir de $x_i$, elle est décompressée pour mettre en oeuvre une boucle de récursion sur la donnée réelle.

Cette approche par modèle réduit a par exemple été proposée dans les publications suivantes :

- Carlberg, K., Farhat, C., Cortial, J., & Amsallem, D. (2013). The GNAT method for nonlinear model reduction: effective implementation and application to computational fluid dynamics and turbulent flows. Journal of Computational Physics, 242, 623-647,

- Chinesta, F., Ladeveze, P., & Cueto, E. (2011). A short review on model order reduction based on proper generalized decomposition. Archives of Computational Methods in Engineering, 18(4), 395-404.

Cette approche n'est pourtant pas sans inconvénient.

En premier lieu, le problème réduit est fortement instable, ce qui signifie qu'une petite perturbation des données entraine une grande déviation de la solution. De ce fait, l'approximation de l'état d'un système physique complexe avec un tel modèle est difficile.

De plus, la minimisation de $\|F\|^2$ implique le calcul d'un résidu, de grande dimension N, un certain nombre de fois, ce qui peut s'avérer coûteux en temps de calcul. Or, en raison du problème d'instabilité, le résidu doit être minimisé avec la plus grande précision à chaque étape. Par conséquent les méthodes actuelles sont insuffisamment précises pour décrire des systèmes physiques complexes non linéaires, et trop coûteuses en temps de calcul pour pouvoir être utilisées en temps réel dans des systèmes embarqués.

L'idée de base de ces méthodes est d'extraire du logiciel de simulation des informations de modélisation à travers le calcul de résidu. Notre approche est tellement parcimonieuse, qu'elle arrive à capturer les phénomènes physiques et biologiques véhiculés par les données.

Ainsi il n'existe pas à ce jour de solution permettant de modéliser avec précision et rapidité un système physique complexe, sur des temps longs, afin de le reproduire sous la forme d'une copie numérique.

On connaît de US 9,336,483 des structures de réseaux neuronaux dynamiquement mises à jour pour les réseaux de distribution de contenu. Il décrit en particulier l'entrainement de réseaux neuronaux, y compris la génération et l'entrainement de pluralités de réseaux neuronaux candidats et la sélection d'un réseau parmi les réseaux candidats pour des applications dans des réseaux de distribution de contenu. Les documents suivants divulguent d'autres caractéristiques pertinentes pour la présente invention: HONGLEI ZHANG ET AL: "Finding Better Topologies for Deep Convolutional Neural Networks by Evolution",ARXIV.ORG, CORNELL UNIVERSITY LIBRARY, 201 OLIN LIBRARY CORNELL UNIVERSITY ITHACA, NY 14853, 10 septembre 2018; https://web.archive.org/ web/20180920073216/https://www. adagos.com/ ; GAO HUANG ET AL: "Orthogonal Least Squares Algorithm for Training Cascade Neural Networks",IEEE TRANSACTIONS ON CIRCUITS AND SYSTEMS I: REGULAR PAPERS, IEEE, US, vol. 59, no. 11, 1 novembre 2012 (2012-11-01), pages 2629-2637, ISSN: 1549-8328, DOI: 10.1109/TCSI.2012.2189060; US 5 636 326 A.

**Exposé de l'invention**

L'invention a pour objet de remédier aux lacunes de l'art antérieur décrites ci-avant, basé sur l'utilisation de réseaux neuronaux redondant pour l'apprentissage de phénomènes réels représentant des systèmes réels.

En particulier, un but de l'invention est de proposer une méthode de simulation dynamique d'un système physique complexe pourvue d'excellentes capacités de prédiction sur des temps longs et qui soit plus rapide que le temps réel du système physique.

Un autre but de l'invention est d'être applicable à la modélisation tant statique que dynamique de systèmes physiques complexes, et d'être applicable également à la compression non linéaire de systèmes complexes. En effet, le taux de compression augmente d'une manière drastique avec la profondeur du réseau. Cette compression est à la base de la prédiction dynamique sur des temps longs.

L'invention a enfin pour but de proposer une structure de réseau de neurones adaptée à l'application qui en est faite ultérieurement, cette structure étant parcimonieuse, c'est-à-dire la plus réduite possible pour nécessiter une quantité faible de données pour son apprentissage.

Plus particulièrement, l'invention a pour objet un procédé selon la revendication 1.

Avantageusement, mais facultativement, la modification de topologie sélectionnée est celle, parmi les modifications candidates, optimisant la variation de l'erreur par rapport à la topologie précédente.

Dans un mode de réalisation, l'erreur du réseau pour une topologie donnée est définie par $J(\Gamma, W^*)$ où

- J est une fonction d'erreur entre une donnée de sortie du réseau et un résultat cible,
- $\Gamma$ est la topologie du réseau, et
- $W^*$ est la matrice des poids de connexion du réseau minimisant la fonction d'erreur J à topologie $\Gamma$ fixée.

Dans un mode de réalisation, la variation de l'erreur du réseau entre une topologie candidate et la topologie précédente est estimée en calculant la quantité : $J(\Gamma^n, \tilde{W}^n,) - J(\Gamma^{n-1}, W^{n-1*})$ où par abus de notation, nous notons

$\Gamma^n$ la topologie du réseau candidate à l'itération n,

$\tilde{W}^n$ est une matrice des poids de connexion du réseau après au moins une itération d'apprentissage du réseau suite à la modification topologique candidate à l'itération n, et

$W^{n-1*}$ est la matrice des poids de connexion du réseau d'itération n-1 minimisant la fonction d'erreur J avec la topographie $\Gamma^{n-1}$ fixée.

$\tilde{W}^n$ peut alors être initialisé avec les mêmes poids de connexion que la matrice $W^{n-1*}$ pour les connexions communes aux deux topologies et, dans le cas d'une phase additive, un poids de connexion nul pour chaque lien créé lors de la phase additive.

Dans un mode de réalisation, l'estimation de la variation de l'erreur du réseau entre une topologie modifiée et la topologie précédente comprend l'estimation de l'erreur du réseau selon la topologie modifiée à partir de l'opérateur de Lagrange appliqué aux poids de connexion du réseau de neurones $(\Gamma, W, \mathbf{X}, \Lambda)$ où :

$\mathcal{L}$ est l'opérateur de Lagrange,

$\Gamma$ est la topologie du réseau,

$W$ est une matrice de poids de connexion du réseau,

$\mathbf{X} = (X^0, \ldots, X^{nc})$ représente les sorties de l'ensemble des nœuds du réseau et $X^i$ représente les sorties des nœuds de la couche i, et

$\Lambda_i$ est le multiplicateur de Lagrange associé à l'expression définissant les éléments de la couche $X^i$.

Avantageusement, lors d'une phase additive, la variation de l'erreur du réseau entre une topologie candidate et la topologie précédente est estimée en calculant la quantité : $\mathcal{L}(\Gamma^n, W^n, \mathbf{X}, \Lambda) - J(\Gamma^{n-1}, W^{n-1})$ où :

- $\Gamma^n$ est la topologie du réseau candidate à l'itération n,
- $W^{n-1*}$ est la matrice des poids de connexion du réseau de la topologie d'itération n-1 minimisant la fonction d'erreur J pour une topographie fixée,
- $W^n$ est une matrice des poids de connexion du réseau après la modification topologique candidate à l'itération n, ladite matrice étant initialisée avec les mêmes poids de connexion que la matrice $W^{n-1*}$ pour les connexions communes entre la topologie candidate à l'itération n et la topologie d'itération n-1, et un poids de connexion nul pour chaque lien créé lors de la phase additive. Une mise à jour de $W^n$ est ensuite obtenue en minimisant $\mathcal{L}$ par rapport aux poids des liens créés.

Avantageusement, lors d'une phase soustractive, la variation de l'erreur du réseau entre une topologie calculée et la topologie précédente est estimée en calculant la quantité :

$\mathcal{L}(\Gamma^n, W^n, \mathbf{X}, \Lambda) - J(\Gamma^{n-1}, W^{n-1*})$ où $W^n = W^{n-1*}_{|\Gamma^n}$ est une restriction de $W^{n-1*}$ à la topologie $\Gamma^n$.

Dans un mode de réalisation, le procédé comprend, une fois la modification de topologie sélectionnée, la détermination d'une matrice des poids de connexion du réseau par une méthode de descente de l'erreur par rapport à ladite matrice. Cette étape est un apprentissage du réseau à la topologie obtenue à l'issue de la modification topologique.

Contrairement à l'état de l'art, ce processus d'apprentissage est basé sur une méthode de descente ayant une convergence rapide de type Gauss-Newton.

Avantageusement, l'étape d'optimisation topologique est mise en œuvre en fonction d'erreurs moyennes du réseau de neurones sur des données d'apprentissage d'une part, et sur des données de validation d'autre part, dans lequel :

- au moins une étape additive est mise en œuvre pour faire baisser l'erreur sur les données d'apprentissage,

 au moins une étape soustractive est mise en œuvre, si l'erreur sur les données d'apprentissage devient inférieure à l'erreur sur les données de validation au-delà d'une tolérance prédéterminée, et

 l'optimisation topologique est arrêtée lorsque toute étape additive ou soustractive ne résulte plus en une diminution de l'erreur sur les données d'apprentissage et sur les données de validation.

Le procédé peut en outre comprendre la mise en œuvre itérative :

- d'une étape de subdivision de la couche centrale par une nouvelle première couche intermédiaire, une nouvelle couche centrale, et une nouvelle deuxième couche intermédiaire,

de redéfinition des blocs de compression et de décompression pour inclure les couches obtenues à l'issue de l'étape de subdivision et

- d'optimisation topologique des blocs de compression et de décompression.

Selon un autre objet, il est décrit un procédé selon la revendication 8.

Selon un autre objet, il est décrit un procédé selon la revendication 9.

L'invention a également pour objet un produit programme d'ordinateur, comprenant des instructions de code pour la mise en œuvre du procédé selon la description qui précède, lorsqu'il est exécuté par un processeur.

Le procédé de construction d'un réseau de neurones utilisé dans l'invention permet d'obtenir un réseau de neurones dont la structure dépend de l'utilisation ou l'application prévue, puisque la construction comprend une phase d'optimisation topologique qui est gouvernée par l'erreur du réseau sur des données d'apprentissage et de validation.

En d'autres termes, le procédé de construction comprend simultanément la construction, et l'apprentissage, pour une tâche spécifique, du réseau de neurones. Ceci permet à un utilisateur de ce procédé de ne pas avoir besoin de disposer de connaissances mathématiques particulières pour choisir une structure de réseau de neurones adaptée à l'application technique visée.

Plus particulièrement, le procédé de construction utilisé dans l'invention permet de construire un réseau de neurones parcimonieux, c'est-à-dire où toute redondance est supprimée, optimisé pour la tâche visée. Cette propriété est obtenue par une construction incrémentale à partir d'une topologie initiale éventuellement minimale, c'est-à-dire comprenant une seule couche cachée comprenant un seul neurone, puis en mettant en oeuvre un processus itératif comprenant une étape d'apprentissage en l'état courant du réseau, en utilisant une méthode à convergence locale rapide, telle que la méthode de Gauss-Newton, et une étape de modification topologique du réseau pour améliorer l'apprentissage. De plus, la mise en oeuvre d'une technique d'optimisation topologique dans la construction joue un double rôle :

- Eviter les minima locaux, où à chaque convergence (rapide) du processus d'apprentissage, la technique d'optimisation topologique additive enrichit le réseau neuronal par l'élément (nœud ou lien) qui améliore le mieux l'apprentissage. En effet, l'état de l'art évite les minima locaux par la redondance non contrôlée et nous évitons les minima locaux par un enrichissement contrôlé par le gradient topologique.
- Créer un réseau neuronal parcimonieux, et en particulier réduire sa profondeur afin d'atténuer les problèmes d'apprentissage mentionnés ci-dessus, et permettre l'apprentissage du réseau y compris avec des données rares ou en faibles quantités.

Le procédé d'optimisation topologique donne au réseau neuronal une structure innovante dans la mesure où un neurone d'une couche, y compris la couche de sortie, peut être relié à un neurone de n'importe quelle couche précédente, y compris la couche d'entrée. En effet, lorsqu'un phénomène physique dépend d'un grand nombre de paramètres, la plupart de ces paramètres contribuent d'une manière linéaire à la réponse du système. D'où l'intérêt de connecter les entrées correspondantes directement à la couche de sortie du réseau neuronal. L'effet de paramètres faiblement non linéaires peut être pris en compte par une seule couche intermédiaire entre l'entrée et la sortie et ainsi de suite.

La réduction de la complexité du réseau neuronal améliore de fait sa capacité de généralisation (aptitude à donner la bonne réponse sur des données non apprises), Cela permet également d'atténuer les difficultés d'apprentissage (gradients explosifs et gradients évanescents) en réduisant le nombre de couches. En effet, dans un réseau structuré en couches, certaines cellules peuvent servir tout simplement à dupliquer des cellules antérieures afin de les rendre disponibles pour la couche qui suit. Cela augmente la complexité du réseau d'une manière inutile.

Ce réseau de neurones, utilisé pour la modélisation d'un système physique complexe, permet une très bonne qualité de simulation pour des temps de calculs réduits, et notamment inférieurs au temps réel du système physique. Le modèle de simulation peut être construit à partir de mesures effectuées pendant le fonctionnement normal du système physique ou pendant des phases de test.

De plus, l'optimisation topologique du réseau est avantageusement menée par l'utilisation de l'opérateur de Lagrange, ou lagrangien, appliqué aux poids de connexion du réseau de neurones. Cette méthode permet de calculer de façon particulièrement rapide l'effet d'une modification topologique du réseau (ajout/élimination d'une cellule neuronale, ajout élimination d'un lien), ce qui permet de rapidement évaluer et sélectionner à chaque étape la meilleure amélioration topologique du réseau de neurones.

Le réseau de neurones à propagation avant est avantageusement utilisé, comme motif récurrent, dans le cadre de la simulation dynamique de systèmes physiques pour prédire un état futur du système en fonction d'un état initial et d'éventuels termes sources ou excitations.

Le réseau de neurones est avantageusement combiné à une approche dans laquelle les données représentatives de l'état du système physique sont compressées. Le modèle dynamique simule l'état futur du système sur les données compressées, puis décompresse les données simulées pour revenir à l'espace réel. Contrairement à l'état de la technique portant sur les bases réduites décrit ci-avant, la boucle de récursion ne se fait pas dans l'espace réel mais dans l'espace des données comprimées, ce qui élimine le bruit sur les données tout en assurant une meilleure stabilité du modèle dynamique. Ceci permet également de réduire les temps de calcul dans les phases d'apprentissage et de simulation.

L'optimisation topologique joue un rôle majeur dans la maîtrise des modèles dynamiques. En effet, si l'on effectue m itérations d'un motif récurrent ayant n couches, la difficulté d'apprentissage est équivalente à celle d'un réseau neuronal ayant n x m couches. L'invention permet donc de réduire n, et par conséquent le nombre de calculs et leur durée, de deux manières différentes :

- Par la compression qui réduit la taille du motif récurrent,
- Par l'optimisation topologique qui réduit le nombre de couches du motif récurrent.

**Brève description des dessins**

D'autres caractéristiques, détails et avantages de l'invention apparaîtront à la lecture de la description détaillée ci-après, et à l'analyse des dessins annexés, sur lesquels :

[Fig. 1] déjà décrite, représente schématiquement un procédé de simulation dynamique au moyen d'une base réduite de projection.

[Fig. 2] représente schématiquement un système pour la mise en œuvre d'un procédé de construction d'un réseau de neurones et de simulation d'un système physique.

[Fig. 3] représente schématiquement les principales étapes de construction d'un réseau de neurones selon un mode de réalisation de l'invention.

[Fig. 4a] représente un exemple de réseau de neurones obtenu par un logiciel de l'état de la technique pour une application donnée. Il s'agit du meilleur résultat obtenu par le logiciel de l'état de la technique, après avoir effectué cinquante expériences d'essai sur erreur.

[Fig. 4b] représente un exemple de réseau de neurones obtenu par la mise en œuvre du procédé de construction selon un mode de réalisation de l'invention pour la même application que celle de la [Fig. 4a].

[Fig. 4c] représente un autre exemple de réseau de neurones obtenu par la mise en œuvre du procédé de construction selon un mode de réalisation de l'invention pour la modélisation d'un système complexe impliquant des interactions fluide-structure dans le domaine de l'automobile.

[Fig. 5] représente schématiquement un exemple de construction de réseau de neurones comprenant un bloc de compression et un bloc de décompression.

[Fig. 6a] représente la mise en œuvre d'un procédé de modélisation dynamique selon une variante de réalisation de l'invention.

[Fig. 6b] représente la mise en œuvre d'un procédé de modélisation dynamique selon une autre variante de réalisation de l'invention.

[Fig. 7a] représente schématiquement en vue de dessus une installation pour la mesure de la progression d'un front de fusion de sodium.

[Fig. 7b] représente trois différentes commandes de puissance d'une résistance électrique de l'installation de la figure 7a.

[Fig. 8a] représente le réseau de compression/décompression réalisé pour modéliser les données des capteurs de l'installation de la figure 7a.

[Fig. 8b] représente le réseau de modélisation dynamique réalisé pour modéliser les données des capteurs de l'installation de la figure 7a.

[Fig. 9a] représente, pour un capteur de l'installation de la figure 7a, une comparaison entre les données du capteur et les données de modélisation pour une des trois commandes de puissance de la figure 7b.

[Fig. 9b] représente, pour un capteur de l'installation de la figure 7a, une comparaison entre les données du capteur et les données de modélisation pour une autre des trois commandes de puissance de la figure 7b.

[Fig. 9c] représente, pour un capteur de l'installation de la figure 7a, une comparaison entre les données du capteur et les données de modélisation pour une dernière des trois commandes de puissance de la figure 7b.

## Description des modes de réalisation

On va maintenant décrire un procédé de construction d'un réseau de neurones parcimonieux pouvant être utilisé pour la modélisation d'un système ou phénomène physique. Ce procédé, ainsi que les procédés de compression de données, de simulation d'un système statique ou dynamique décrits ensuite, sont mis en oeuvre par un ordinateur 1 représenté schématiquement en figure 2, comprenant un calculateur (par exemple un processeur) 10, et une mémoire 11, le calculateur étant adapté pour exécuter des instructions stockées dans la mémoire 11 pour la mise en oeuvre de ces procédés. L'ordinateur comprend avantageusement ou peut être connecté à au moins un capteur 12 adapté pour acquérir des mesures de grandeurs physiques.

Le procédé comprend deux phases : une phase d'apprentissage et de construction du modèle, et une phase de simulation pour l'exploitation du modèle. Les deux phases peuvent être effectuées sur des équipements différents. Seule la phase de simulation a vocation à relever du temps réel.

Dans toute la suite, on appelle système réel tout système dont l'état peut au moins en partie être mesuré par des capteurs de grandeurs physiques. Parmi les systèmes réels on recense notamment les systèmes physiques, biologiques, chimiques et informatiques.

On suppose que le système réel que l'on cherche à modéliser est régi par une modèle de type :

$$Y = f(X) \qquad (1)$$

où X et Y sont respectivement des variables d'entrée et de sortie caractérisant l'état du système.

Pour la construction de ce modèle, on dispose d'une base de données de type $(X_i, Y_i)_{i=1}^{M}$, engendrés par des mesures sur le système réel, les données pouvant être stockées dans la mémoire 11, où :

$X_i \in \Re^{n_0}$ est une donnée d'entrée comprenant un nombre $n_0$ de composantes, dont la dernière, à titre d'exemple, est fixée à 1 et les $n_0$-1 restantes correspondent typiquement à des grandeurs physiques représentatives de l'état du système, ces données ayant été mesurées au moyen de capteurs 12, et

$Y_i \in \Re^{n_0}$ est une donnée de sortie comprenant un nombre $n_o$ de composantes, qui correspondent à d'autres grandeurs physiques du système, ces données ayant également été mesurées au moyen de capteurs 12.

Cette base de données est répartie en deux sous-ensembles disjoints, dont le premier constitue une base de données d'apprentissage formée par les indices, par exemple, i = 1,...,$M_1$, $M_1$<M, et le reste des indices forme une base de données de validation. Le but de cette répartition est la mise en œuvre d'une méthode de validation croisée sur l'apprentissage du réseau de neurones construit.

L'objectif du procédé de modélisation du système physique est de construire un modèle approché de (1) de la forme :

$$Y \approx f_{\Gamma,W}(X) \qquad (2)$$

où $f_{\Gamma,W}$ est une fonction de simulation calculée par un réseau de neurones défini par une topologie $\Gamma$ et une matrice ou une liste de matrices de poids de connexion W, de manière à pouvoir simuler la sortie Y à partir d'une variable d'entrées X.

La topologie $\Gamma$ et la matrice W des poids de connexion sont déterminées par la minimisation d'une fonction d'erreur J du réseau de neurones :

$$\min_{\Gamma,W} J(\Gamma, W) \qquad (3)$$

Où J quantifie l'erreur entre une sortie du réseau de neurones calculée sur la base de données d'entrée $X_i$ et le résultat cible correspondant $Y_i$, calculée sur la base de données d'apprentissage :

$$J(\Gamma, W) := \sum_{i=1}^{M1} \left|\left| f_{\Gamma,W}(X_i) - Y_i \right|\right|^2, \qquad (4)$$

## Réseau de neurones

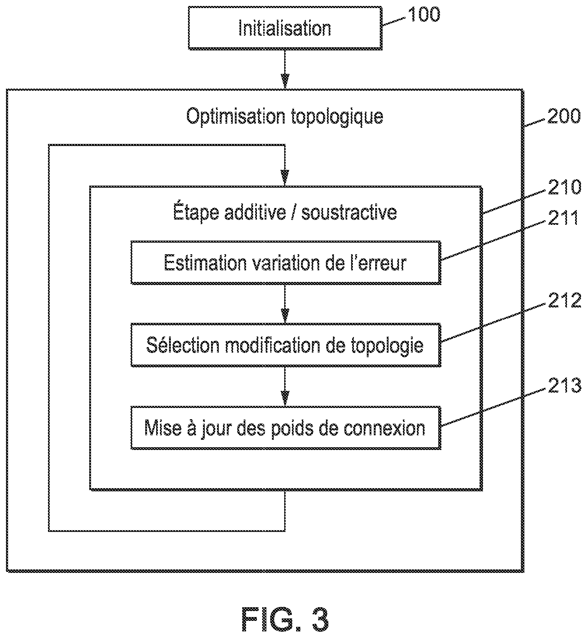

En référence à la figure 3, on a représenté schématiquement un procédé de construction d'un réseau de neurones utilisé pour la modélisation du système physique.

Ce réseau de neurones comprend un ensemble de nœuds de traitement, également appelé neurones, et de connexions entre les nœuds de traitement, chaque connexion étant pondérée d'un coefficient de pondération, les nœuds de traitement et les connexions formant une topologie organisée en couches.

Contrairement à un réseau de neurones classique dont chaque couche prend ses entrées sur les sorties de la précédente et n'est donc connectée qu'à la couche précédente, le réseau de neurones selon l'invention est un graphe de calcul, dont chaque couche est définie par l'ensemble des nœuds qui peuvent être calculés simultanément, et l'entrée d'un nœud de traitement d'une couche peut être connectée à la sortie d'un nœud de traitement de n'importe laquelle des couches précédemment calculées.

En conséquence aussi, l'ensemble des nœuds de traitement calculant les sorties du réseau de neurones, ci-après appelé « ensemble des nœuds de sortie », ne forme pas une couche car les nœuds de sortie peuvent être calculés à des étapes différentes et être répartis entre plusieurs couches.

De plus, le réseau de neurones est de type propagation avant, c'est-à-dire qu'il ne comprend aucune boucle de calcul ramenant la sortie d'un nœud de traitement en entrée du même nœud ou d'un nœud d'une couche précédente.

Enfin, l'apprentissage du réseau de neurones est réalisé pendant sa construction, de manière à adapter la structure du réseau de neurones à la fonction qu'il doit calculer.

On note $X_i$, i=1,...,nc la couche formée par les cellules que l'on peut calculer simultanément lors de l'étape i et $\mathbf{X}^i =$ $(X^0,...,X^i)$ les couches déjà calculées à l'étape i. On pose $X^0 = (X_i)_{i=1}^{M1}$ qui est de taille $n_0$ x M1 et représente l'état de la couche d'entrée (en d'autres termes on applique le réseau de neurones aux données de la base de données que l'on possède). On pose Y = $Y = (Y_i)_{i=1}^{M1}$, les valeurs cibles correspondant à l'entrée $X^0$.

En notant nc le nombre de couches du réseau de neurones, et en associant à la couche i un nombre ni de nœuds de traitement, on associe une matrice des poids de connexions $W_i$ de taille $n_{i+1} \times \Sigma_{j \leq i} n_j$ à chaque couche. La matrice $W_i$ est très creuse. La plupart de ses colonnes sont nulles et celles qui ne sont pas nulles contiennent beaucoup de zéros. L'ensemble des poids de connexion de l'ensemble du réseau de neurones est alors W = ($W_0$, ... ,$W_{nc-1}$). Par abus de langage, nous appellerons cet objet matrice.

Le réseau de neurones met alors en œuvre les calculs suivants (ci-après décrit comme « l'algorithme de calcul ») sur les données d'entrée X0 :

X0 = *X*0

Pour i = 1 à nc,

$$X^i = f_{SI}\big(W_{i-1} * \mathbf{X}^{i-1}\big)$$

$$\mathbf{X}^i = \big(\mathbf{X}^{i-1}, X^i\big) ;$$

Fin

Où la fonction $f_{SI}$ est la fonction Identité pour les nœuds de traitement de sortie et le sigmoïde : $f_{SI}(x) = \frac{1}{1+exp(-x)}$ pour les autres nœuds de traitement. On suppose que, par exemple, la dernière ligne, de $x^0$ est formée par des 1. Cela veut dire que la dernière cellule de la couche d'entrée est une cellule de biais. Dans les architectures classiques, chaque couche, autre que la couche de sortie a une cellule de biais. Dans l'architecture selon cette invention, seule la couche d'entrée a une cellule de biais. Les cellules des autres couches peuvent se connecter directement à cette cellule.

La fonction d'erreur J du réseau de neurones s'écrit alors : $J = \big|\big| O\,\mathbf{X}^{nc} - Y \big|\big|^2$

Où O est la matrice d'observation permettant d'extraire les éléments de sortie de Xnc. En effet, le nombre de cellules de la dernière couche noté $n_{nc}$ est inférieur ou égal à la taille des données de sortie du réseau neuronal $n_o$. C'est

pour cette raison que l'opérateur d'observation s'applique à $X_{nc}$, c'est-à-dire à toutes les cellules du réseau.

La topologie $\Gamma$ du réseau de neurones est définie par les matrices d'incidences du graphe de calcul $\Gamma = (M_0,...,M_{nc-1})$, où $M_i$ est une matrice d'incidence qui a la même taille que $W_i$ qui vaut 1 pour les coefficients non nuls de $W_i$ et zéro ailleurs.

De retour à la figure 3, le procédé de construction du réseau de neurones comprend une première étape 100 d'initialisation d'un réseau de neurones selon une topologie initiale qui peut être minimale, à savoir comprendre :

- Une couche d'entrée, comprenant un ensemble de nœuds de traitement d'entrée dont le nombre de nœuds est imposé par le nombre $n_o$ de données d'entrée incluant un biais,
- Une couche de sortie dont le nombre de nœuds $n_{nc}$ est inférieur au nombre $n_o$ de données de sortie, et
- Au moins une couche cachée contenant au moins un neurone.

L'étape d'initialisation comprend également une détermination des poids de connexion optimaux $W^{1*}$, c'est-à-dire des poids de connexion minimisant la fonction d'erreur J pour la topologie initiale $\Gamma^1$ fixée, notée $J(\Gamma^1, W^{1*})$. Cette détermination est réalisée par entrainement du réseau de neurones sur les données d'apprentissage.

On peut utiliser à cet effet, la rétropropagation du gradient, mais les phénomènes quantitatifs et profonds nécessitent l'utilisation de la méthode de Gauss-Newton zéro-mémoire, décrite dans

- Fehrenbach, J., Masmoudi, M., Souchon, R., & Trompette, P. (2006). Detection of small inclusions by elastography. Inverse problems, 22(3), 1055.

La méthode de Gauss Newton zéro mémoire combine la rétropropagation du gradient avec une méthode de propagation avant du gradient. Elle permet d'améliorer considérablement, la convergence locale.

Le procédé comprend ensuite au moins une phase d'optimisation topologique 200 du réseau de neurones, déterminée de manière à diminuer l'erreur J du réseau.

La phase d'optimisation topologique peut comprendre :

- au moins une phase additive, dans laquelle au moins un nœud de traitement et/ou au moins une connexion est ajouté(e) au réseau de neurones, la connexion ajoutée étant telle qu'elle relie l'entrée d'un neurone à la sortie d'un neurone de n'importe quelle couche précédente, et/ou
- au moins une phase soustractive, dans laquelle au moins un nœud de traitement et/ou au moins une connexion est supprimée du réseau de neurones.

De plus, chaque modification de topologie 210, additive ou soustractive, comprend la sélection 212 parmi une pluralité de modifications topologiques candidats, à partir d'une estimation 211 de la variation de l'erreur du réseau entre chaque topologie modifiée selon une modification candidate et la topologie précédente, la modification topologique sélectionnée étant celle qui optimise la variation de l'erreur par rapport à la topologie précédente, avec l'objectif de maximiser la diminution de l'erreur à chaque itération. Comme on va le voir, cependant, des modifications de topologie soustractives peuvent induire à une itération donnée une augmentation de l'erreur J sur les données d'apprentissage, mais permettent cependant d'améliorer la précision du réseau en réduisant son erreur sur les données de validation.

Il reste à définir le choix des modifications topologiques candidats. Dans le cas d'une phase soustractive, tous les nœuds et les liens sont candidats à une modification topologique à tour de rôle.

Dans une phase additive, on peut connecter par un lien, deux nœuds qui n'appartiennent pas à la même couche et qui ne sont pas déjà connectés. On peut ajouter des nœuds à n'importe quelle couche, autre que les couches d'entrée et de sortie du réseau. On peut également créer une nouvelle couche en insérant un nœud entre deux couches successives. Un nœud créé doit être connecté au réseau avec au moins deux liens, au moins un lien d'entrée et au moins un lien de sortie. Le choix des liens à ajouter peut se faire d'une manière aléatoire. Dans une phase additive, si le réseau est de grande taille, on peut choisir un millier de modifications topologiques candidats prises au hasard. On calcule l'estimation de la variation pour ces perturbations candidats. Les meilleures perturbations,

- celles qui réalisent la plus petite augmentation estimée de l'erreur J, pour une phase soustractive,
- celles qui offrent la plus forte baisse estimée de l'erreur J, pour une phase additive, sont retenues pour définir la topologie $\Gamma^n$.

La variation d'erreur du réseau entre une topologie modifiée (candidate à l'itération n) et la topologie précédente (itération n-1) est mesurée avec les poids de connexions optimaux pour chaque topologie considérée, c'est-à-dire qu'elle s'écrit :

$$J(\Gamma^n, W^{n*}) - J(\Gamma^{n-1}, W^{n-1*})$$

où $\Gamma^n$ est la topologie modifiée selon la modification candidate à l'itération n, et $W^{n*}$ et la matrice des poids de connexion optimaux pour cette topologie.

Cependant le calcul d'une matrice des poids de connexion optimaux pour une topologie donnée est très long, et il n'est pas aisé de calculer cette variation d'erreur pour toutes les modifications topologiques candidates considérées.

On va donc décrire comment on estime cette variation d'erreur plutôt que de la calculer.

Selon un premier mode de réalisation, pour une phase additive, on initialise les poids de connexion $W^n$ de la topologie modifiée par :

$$W^n = W^{n-1*}_{|\gamma}$$ , avec $\gamma$ l'ensemble des liens de $\Gamma^n$ inclus dans celui de $\Gamma^{n-1}$, et

Les autres liens de $\Gamma^n$ sont initialisés à 0.

Cette initialisation ne dégrade pas l'erreur, nous avons $J(\Gamma^n, W^n) = J(\Gamma^{n-1}, W^{n-1*})$.

Puis on effectue quelques itérations d'apprentissage pour améliorer W" et on estime la variation de l'erreur par : $J(\Gamma^n, W^n) - J(\Gamma^{n-1}, W^{n-1*})$, qui est forcément négative ou nulle. Le but de la phase additive est d'assurer l'apprentissage.

Dans le cas d'une phase soustractive, on initialise les poids de connexion W" de la topologie modifiée par

$$W^n = W^{n-1*}_{|\gamma}$$ , puis on peut procéder à quelques itérations d'apprentissage pour améliorer W".

L'estimation de l'erreur est alors aussi : $J(\Gamma^n, W^n) - J(\Gamma^{n-1}, W^{n-1*})$.

Cette variation est forcément positive ou nulle. Sinon $W^{n-1*}$ n'est pas optimale. En effet, la matrice W" offrirait une meilleure solution en mettant à zéro les liens enlevés. Cette phase, qui ne fait qu'augmenter l'erreur, a pour vocation d'assurer la généralisation : la capacité de prédiction du réseau neuronal sur des données qui ne font pas partie de l'ensemble d'apprentissage. Lorsque la fonction erreur J augmente, l'erreur moyenne sur les données de validation a tendance à diminuer.

Selon une variante de réalisation plus avantageuse, l'estimation de l'erreur entre une topologie modifiée et la topologie précédente est réalisée à partir de l'opérateur de Lagrange, ou lagrangien, appliqué aux variables internes du réseau neuronal que sont les couches du réseau $X = (X^0, ...., X^{nc})$, qui s'écrit :

$$\mathcal{L}(\Gamma, W, \mathbf{X}, \Lambda) = J(\Gamma, W) + \sum_i tr(\Lambda_i^T(X^i - f_{SI}(W_{i-1} * \mathbf{X}^{i-1}))) \quad (5)$$

Où $\Lambda = (\Lambda_i)$, $\Lambda_i$ étant le multiplicateur de Lagrange associé à l'équation définissant $X^i$. Le multiplicateur $\Lambda_i$ a la même taille que $X^i$. La fonction tr est la trace, c'est-à-dire la somme des termes diagonaux d'une matrice. D'après l'algorithme de calcul décrit ci-avant du réseau de neurones, si W et $X^0$ sont connus il est possible de construire tous les $X^i$ et ensuite tous les $\Lambda_i$. Les $\Lambda_i$ sont bien définis et sont obtenus en résolvant les équations :

$$\partial_{X^i} \mathcal{L}(\Gamma, W, X_W, \Lambda) = 0, \quad (7)$$

Nous renvoyons à l'Annexe en fin de description pour la résolution de ces équations.

Or on peut constater que pour tout W donné, si X est obtenu par l'algorithme de calcul décrit ci-avant, alors les termes sous le signe somme de l'équation (5) s'annulent et on obtient l'égalité suivante : $J(\Gamma, W) = \mathcal{L}(\Gamma, W, \mathbf{X}_W, \Lambda)$ (6)

Ainsi pour tout W on dispose d'une égalité entre l'erreur du réseau de neurones et du lagrangien appliqué à celui-ci. On en déduit :

$$d_W J(\Gamma, W)\delta W = d_W \mathcal{L}(\Gamma, W, \mathbf{X}_W, \Lambda)\delta W \quad (8)$$

où $d_W$ est la dérivée totale par rapport à W et $\delta W$ est la variation de W. Comme J ne dépend de W que via **X,** la dérivée totale s'écrit :

$$d_W J(\Gamma, W)\delta W = \partial_W J(\Gamma, W)\delta W + \partial_X J(\Gamma, W) \partial_W X \delta W = 2(OX^{nc} - Y) \partial_W X \delta W. \quad (9)$$

Ici la dérivée totale $d_W$ tient compte de $\partial_W$, la dérivée partielle par rapport à W, et de la variation via la variable X. Cette expression est inexploitable en raison du coût de calcul de $\partial_W X$. D'après l'égalité (6), cette dérivée de J peut aussi être calculée d'une manière explicite sans avoir à calculer $\partial_W X$ :

$$d_W J(\Gamma, W)\delta W = d_W \mathcal{L}(\Gamma, W, \mathbf{X}_W, \Lambda)\delta W$$

$$= \partial_W \mathcal{L}(\Gamma, W, \mathbf{X}_W, \Lambda)\delta W + \partial_X \mathcal{L}(\Gamma, W, \mathbf{X}_W, \Lambda)\partial_W \mathbf{X}\delta W \qquad (10)$$

Or comme par construction de $\Lambda$, nous avons $\partial_X \mathcal{L} = 0$ et donc on obtient la formule suivante :

$$d_W J(\Gamma, W)\delta W = \partial_W \mathcal{L}(\Gamma, W, \mathbf{X}_W, \Lambda)\delta W \qquad (11)$$

Les $\Lambda_i$ sont choisis pour que la variation du lagrangien par rapport aux $X^i$ soit nulle. Le lagrangien se comporte comme si on avait éliminé la variable $X^i$ localement. Il en résulte que pour tout $W_0$ fixé, on calcule $X_{W_0}$ et $\Lambda_{W_0}$ et pour tout $W$ proche de $W_0$ on a :

$$J(\Gamma, W) \sim \mathcal{L}\left(\Gamma, W, \mathbf{X}_{W_0}, \Lambda_{W_0}\right). \qquad (12)$$

Ce résultat est avantageusement transposé à la sélection d'une modification topologique candidate qui minimise la fonction d'erreur. En effet, on peut alors, pour une modification topologique soustractive à l'itération n, estimer la variation de l'erreur du réseau entre une topologie $\Gamma^n$ calculée selon une modification candidate et la topologie précédente $\Gamma^{n-1}$ est estimée en calculant la quantité :

$$\mathcal{L}(\Gamma^n, W^n, \mathbf{X}, \Lambda) - J(\Gamma^{n-1}, W^{n-1*}), \qquad (13)$$

Où $W^n = W^{n-1*}_{|\Gamma^n}$ est une simple restriction de $W^{n-1*}$ à la nouvelle topologie $\Gamma^n$. La quantité (13) est calculable rapidement et permet donc de sélectionner la meilleure modification candidate à chaque itération.

Dans le cas d'une modification topologique additive, la variation de l'erreur du réseau entre une topologie calculée et la topologie précédente est estimée en calculant la quantité :

$$\mathcal{L}(\Gamma^n, W^n, \mathbf{X}, \Lambda) - J(\Gamma^{n-1}, W^{n-1*}) \qquad (14)$$

où $W^n$ est une matrice des poids de connexion du réseau après la modification topologique candidate à l'itération n, ladite matrice étant initialisée avec les mêmes poids de connexion que la matrice $W^{n-1*}$ pour les mêmes connexions et un poids de connexion nul pour chaque lien créé lors de la phase additive. A ce niveau d'initialisation, la variation donnée par (14) est égale à zéro. Pour estimer la variation potentielle, après une phase d'apprentissage, il suffit de minimiser le lagrangien par rapport aux seuls liens créés. C'est une forme d'application du principe de Pontryagin :

- Ross, I. M. (2015). A primer on Pontryagin's principle in optimal control (Vol. 2). San Francisco, CA: Collegiate publishers.

Les estimations de variation de l'erreur (13) et (14) peuvent être améliorées par une mise à jour des $W^n$ :

- Il suffit d'appliquer à W" une ou deux itérations d'apprentissage à $\Gamma^n$ fixé,

- Par analogie avec le principe de minimisation de Pontryagin, on peut minimiser $\mathcal{L}(\Gamma^n, W^n, \mathbf{X}, \Lambda)$ par rapport à $W^n$. Cette minimisation se fait à $\mathbf{X}$ et $\Gamma^n$ fixés.

De retour à la figure 3, la phase d'optimisation topologique 200 comprend typiquement plusieurs modifications topologiques de chaque type additif et soustractif.

Les phases additives sont mises en oeuvre pour faire baisser la valeur de l'erreur J sur les données d'apprentissage. Les phases soustractives sont quant à elles mises en oeuvre si l'erreur sur les données d'apprentissage devient inférieure à l'erreur sur les données de validation au-delà d'une certaine limite. Cela signifie en effet que le réseau neuronal a effectué un surapprentissage qui le conduit à donner une mauvaise réponse pour les données non apprises (données de validation).

Enfin, les itérations d'optimisation topologique s'arrêtent lorsque toute modification de topologie ne conduit pas à une amélioration de la précision du réseau, c'est-à-dire lorsqu'elle ne fait plus baisser les erreurs sur les données de validation ni les données d'apprentissage après l'optimisation des poids de connexion.

Enfin, pour chaque phase d'optimisation topologique 200, une fois une modification topologique sélectionnée, le procédé comprend la mise à jour 213 de la matrice des poids de connexion du réseau par une méthode de descente de type rétropropagation du gradient : $W^n \leftarrow W^n - \rho \nabla J(W^n)$ (15)où $\rho$ est le taux d'apprentissage. On peut également utiliser la méthode Gauss-Newton zéro mémoire.

Si l'on compare cette approche avec celle l'état de l'art antérieur, on voit que l'on fait un apprentissage après chaque modification topologique, on a besoin alors d'un algorithme de convergence rapide. L'état de l'art antérieur s'appuie sur la redondance pour éviter les minima locaux. Dans le contexte parcimonieux, les minima locaux sont bien présents, mais l'ajout de nouveaux degrés de liberté, nous permet de modifier localement la fonction d'erreur J.

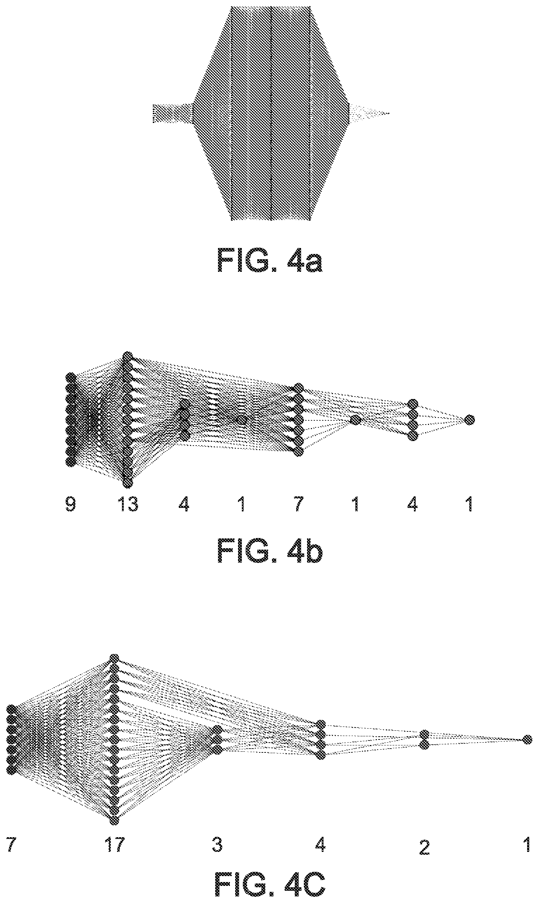

On a représenté sur les figures 4a et 4b un exemple de comparaison entre un réseau de neurones (Figure 4a) obtenu par l'application d'un logiciel de l'état de la technique pour une application de localisation de téléphone et un réseau de neurones construit selon le procédé décrit ci-avant (Figure 4b) pour la même application.

On observe que le réseau neuronal fourni par le logiciel de l'état de la technique est organisé par couches dont chaque couche ne communique qu'avec les couches adjacentes, et ce réseau de neurones comporte 22 420 liens. Celui obtenu en application du procédé ci-avant comprend 291 liens et les couches qui sont visibles ne sont que la visualisation graphique des nœuds de traitement pouvant être calculés simultanément. On constate que les nœuds de traitement d'une couche peuvent communiquer avec les nœuds de toutes les couches précédentes.

*Procédé de simulation*

Une fois le réseau de neurones obtenu et entrainé sur la base de données $(X_i, Y_i)_{i=1}^{M}$ il peut ensuite être appliqué à de nouvelles données que l'on note données $(X_i)_{i \in S}$ théoriques ou acquises par un ou plusieurs capteurs sur le système physique à simuler pour générer des résultats $(Y_i)_{i \in S}$. S représente l'ensemble des données pour la simulation, et il est donc disjoint de l'ensemble des données d'apprentissage et de validation indexées de 1 à M.

Typiquement, les données $(X_i)_{i \in S}$ sont représentatives de certaines grandeurs caractérisant l'état du système réel, ces données pouvant être mesurées, et les données $(Y_i)_{i \in S}$ peuvent être représentatives d'autres grandeurs caractérisant l'état du système physique, ces données pouvant être plus difficiles à mesurer, d'où le besoin de les simuler. Les données $(X_i)_{i \in S}$ peuvent inclure des données de commande ou d'état d'actionneurs, le but de la simulation peut être de déterminer le choix des $(X_i)_{i \in S}$ qui permet d'avoir la meilleure réponse du système $(Y_i)_{i \in S}$.

On peut envisager de nombreuses applications possibles comme par exemple :

- Localisation d'un téléphone mobile à partir de l'intensité des signaux reçus en plusieurs relais téléphoniques,

  Détermination de la consommation énergétique d'un bâtiment à partir de données météorologiques.
  Expression du couple d'un moteur électrique en fonction des trois phases de l'alimentation électrique.

Pour ces trois exemples, une simulation de chaque système a été faite au moyen d'un réseau de neurones selon la description qui précède, comparée à une simulation au moyen du logiciel de l'état de la technique déjà comparé dans la section précédente.

Dans cette comparaison, le réseau de neurones selon l'invention est exécuté une seule fois sur chaque cas test. En revanche le logiciel de l'état de la technique requiert de spécifier le nombre de couches, le nombre de cellules par couches et le poids des liens entre les cellules, de sorte que 50 essais sur erreur ont été faits avec ce logiciel d'état de la technique. [Table 1] ci-dessous fait apparaître la moyenne de l'erreur, l'écart type sur l'erreur et la meilleure erreur obtenue ; on remarque que l'erreur obtenue par le réseau de neurones décrit ci-avant est toujours inférieure à la meilleure erreur obtenue par le logiciel d'état de la technique.

[Table 1]

| | | logiciel d'état de la technique(~50 essais) | Réseau de neurones selon l'invention |
|---|---|---|---|
| Localisation de téléphone | Erreur moyenne | 0.0895 | 0.019 |
| | Ecart-type | 0.09 | - |
| | Meilleure erreur | 0.0193 | - |
| | Nombre de liens | 22 421 | 291 |

(suite)

| | | logiciel d'état de la technique(~50 essais) | Réseau de neurones selon l'invention |
|---|---|---|---|
| Consommation énergétique de bâtiment | Erreur moyenne | 0.0737 | 0.0586 |
| | Ecart-type | 0.0133 | - |
| | Meilleure erreur | 0.0596 | - |
| | Nombre de liens | 12 300 | 116 |
| Couple moteur | Erreur moyenne | 0.02533 | 0.0102 |
| | Ecart-type | 0.2071 | - |
| | Meilleure erreur | 0.0111 | - |
| | Nombre de liens | 28 700 | 232 |

Une autre comparaison peut être faite entre les performances de l'invention appliquée à la modélisation d'un phénomène complexe impliquant des interactions fluide-structure dans le domaine de l'automobile, et des performances obtenues par un acteur majeur du domaine du numérique en exploitant une solution disponible sur le marché. Le réseau de neurones obtenu par l'invention pour cette application est représenté en figure 4c et le comparatif des performances se trouve dans [Table 2] ci-dessous.

[Table 2]

| | Solution de l'état de la technique | Invention |
|---|---|---|
| Données d'apprentissage (Pourcentage de données disponibles) | 1 000 000 échantillons (100 %) | 10 000 échantillons (1%) |
| Taille du réseau (nombre de liens) | 500 000 | 194 |
| Ressources informatiques | Une carte GPU à 15 000 $ | 1 minute 13" sur un portable |
| Consommation énergétique | 1 kWh | 0.0005 kWh |

*Compression*

Le procédé de construction de réseau de neurones décrit ci-avant peut également être utilisé pour la compression de données.

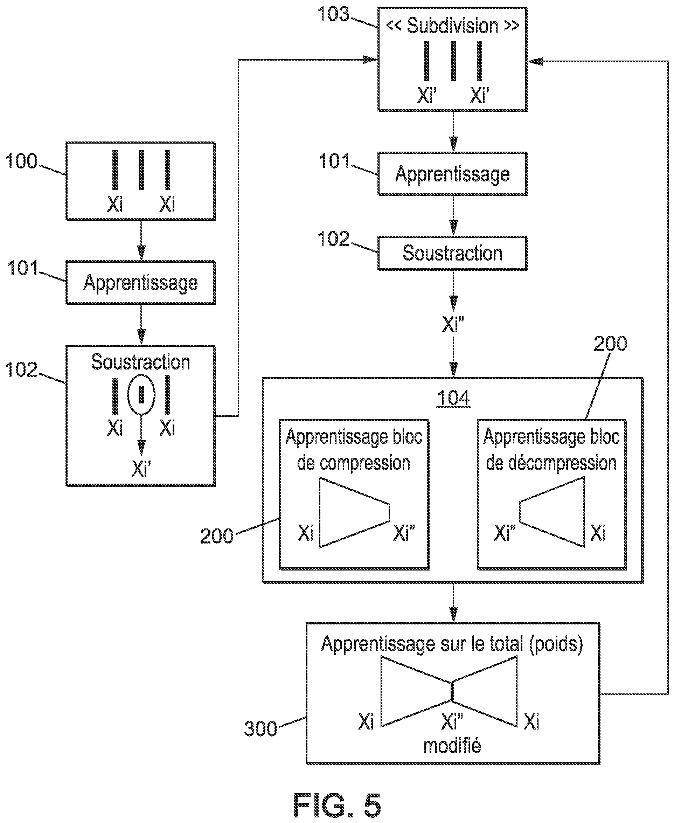

A cet égard, et en référence à la figure 5, on construit un réseau de neurones comprenant un bloc de compression C et un bloc de décompression D, dans lequel le bloc de compression et le bloc de décompression sont des réseaux de neurones construits selon le procédé décrit ci-avant, à l'aide de bases de données d'apprentissage et de validation comprenant des couples de la forme $(X_i, X_i)_{i=1}^{M}$ .

La construction du réseau de neurones de compression comprend une étape d'initialisation 100 d'un réseau de neurones qui comprend :

- Une couche d'entrée recevant une entrée $X_i$,
- Un ensemble de nœuds de traitement formant une couche de sortie générant une sortie $X_i$ identique à l'entrée, et
- Une couche cachée qui a le même nombre de nœuds de traitement que la couche d'entrée et la couche de sortie.

Le procédé comprend ensuite une étape 101 d'apprentissage de ce réseau de neurones initial, sur la base de données d'apprentissage, puis une phase soustractive 102 conforme à une phase soustractive de l'étape d'optimisation topologique décrite ci-avant pour réduire la taille de la couche cachée sans dégrader l'apprentissage. On note $X_i'$ la compression des $X_i$ au niveau de la couche cachée.

Le procédé comprend ensuite une étape de subdivision 103 de la couche cachée en trois couches de même taille, et une réitération de l'étape 101 d'apprentissage sur le sous-réseau constitué, et de l'étape soustractive 102 sur la nouvelle couche centrale.

On définit ensuite lors d'une étape 104 un bloc de compression C qui est constitué par l'ensemble des couches entre la couche d'entrée et la couche centrale, et un bloc de décompression D qui est constitué par l'ensemble des couches entre la couche centrale et la couche de sortie, et on met en oeuvre l'étape 200 d'optimisation topologique de chaque bloc séparément.

Le procédé comprend ensuite une étape 300 d'apprentissage sur l'ensemble du réseau ainsi formé. Les étapes 103 à 300 peuvent ensuite être itérées jusqu'à ce qu'il devienne impossible de réduire la taille du vecteur comprimé sans dégrader significativement l'erreur de décompression.

Le taux de compression obtenu permet de décrire des structures très complexes avec seulement quelques variables. Pour illustrer la puissance de ces méthodes de compression non linéaires, on peut donner un exemple où $X_i = e_i$, le $i^{ème}$ élément de la base canonique. Aucune compression n'est possible par les méthodes linéaires classiques. Mais on constate que les vecteurs $X_i$ sont paramétrés par une seule variable, l'indice i.

Avantageusement, on peut utiliser le bloc de compression, et/ou le bloc de décompression ainsi créés pour modéliser un système réel dont les entrées et/ou les sorties sont de grande dimensionnalité.

Dans le cas d'une entrée de grande dimensionnalité, on peut par exemple insérer un bloc de modélisation juste après le bloc de compression, pour obtenir un réseau de neurones comprenant :

- Un bloc de compression, adapté pour comprimer des données d'entrée $X_i$, tel que $x_i = C(X_i)$,
- Un bloc de modélisation adapté pour calculer sur des données comprimées une fonction $Y_i = f(x_i)$ et,

Ici le bloc de décompression ne sert qu'à s'assurer que les xi représentent bien les Xi en s'assurant que Xi≈D(xi). Dans ce cas le procédé de construction comprend avantageusement au moins une phase d'apprentissage à topologie fixe supplémentaire sur le réseau entier $f \circ C$. Cela permet de corriger la décompression en fonction de l'application, c'est-à-dire de la modélisation. En effet, le processus de compression ignore l'objectif à atteindre $Y_i$.

On peut prendre l'exemple d'un système modélisant le risque de développer une pathologie à partir des caractéristiques génétiques d'un individu. Les données d'entrée du réseau peuvent avoir des centaines de milliers d'entrées, alors que la sortie est réduite à un seul scalaire. Les meilleurs résultats obtenus dans ce domaine sont basés sur le processus indiqué ci-dessus.

Les sorties de grande dimensionnalité donnent lieu à un taux de compression élevé. Ce phénomène peut être expliqué par le lien de cause à effet qui lie les Xi aux Yi. On peut par exemple insérer un bloc de modélisation juste avant le bloc de décompression, pour obtenir un réseau de neurones comprenant :

- Un bloc de modélisation adapté dans lequel on a remplacé les sorties $Y_i$ par leur version comprimée $y_i$, ce qui donne $y_i = f(X_i)$,
- Un bloc de décompression, adapté pour obtenir les données de sortie $Y_i$, à partir de coefficients de compression $y_i$ tel que $Y_i = D(y_i)$.

On peut procéder avantageusement à un apprentissage final à topologie fixe du réseau global $D \circ f$.

Dans la démarche expérimentale, notamment pour les expériences simulées, on peut avoir des $X_i$ de très grande dimension, qui sont par construction non compressibles. Les $Y_i$ qui sont en général compressibles. En effet, la résolution d'équations aux dérivées partielle a un effet régularisant. Le fait de construire le modèle $y_i = f(X_i)$ montre que finalement, dans un certain sens, les $X_i$ sont compressibles : leur effet sur les $Y_i$ est compressible.

*Système dynamique*

Le procédé de construction de réseau de neurones peut également être utilisé pour la modélisation d'un système physique dynamique, dans laquelle on cherche à déterminer un état futur d'un système physique à partir d'informations sur son état actuel.

A cet égard, on construit un réseau de neurones comprenant un bloc de compression, un bloc de modélisation, et un bloc de décompression, dans lequel au moins le bloc de compression et le bloc de décompression sont des réseaux de neurones construits selon le procédé décrit ci-avant, à l'aide de bases de données d'apprentissage et de validation comprenant des couples de la forme $(X_i, X_i)_{i=1}^{M}$.

Ici chaque $X_i$ représente l'état du système à des instants successifs. Si $(z_i)_{i=-p}^{M}$ représente l'état instantané du système étudié, alors $X_i = \begin{pmatrix} z_i \\ z_{i-1} \\ \vdots \\ z_{i-p} \\ 1 \end{pmatrix}$.

Pour des raisons expliquées ci-avant le biais est ajouté aux données. Dans les méthodes telles que la méthode ARMA ou les réseaux récurrents de type NARX, l'étape qui suit dépend de p+1 étapes précédentes. L'utilisation de cette technique améliore la stabilité du modèle. Mais elle augmente également la taille du modèle et réduit sa capacité de généralisation.

La compression des $X_i$ permet de réduire la taille du motif récurrent, tout en augmentant p pour assurer une meilleure stabilité.

Cette compression présente l'avantage de filtrer le bruit des $X_i$, ce qui est essentiel dans le contexte de données mesurées.

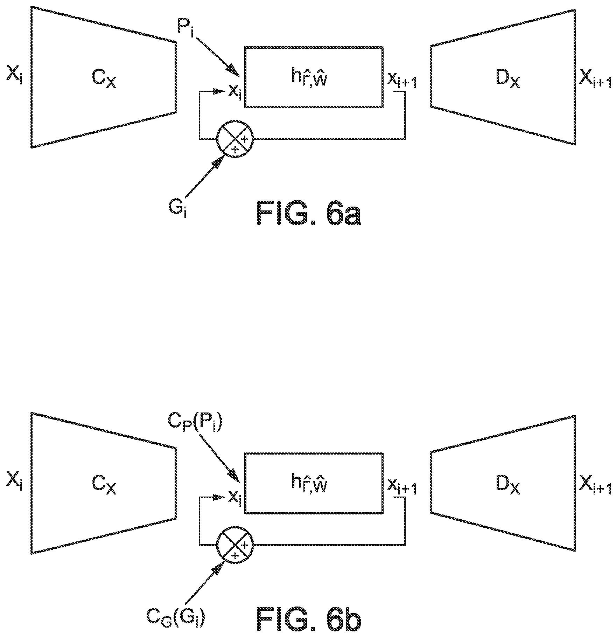

Pour la modélisation d'un système physique dynamique, en référence aux figures 6a et 6b, on insère entre le bloc de compression C et le bloc de décompression D construits conformément à la description qui précède, un bloc h adapté pour modéliser le comportement dynamique du système réel, qui est de la forme : $X_{i+1} = F(X_i, P_i) + G_i,\ i \geq 0$ (16) où $G_i$ correspond à une ou plusieurs excitations représentant l'environnement du système simulé et $P_i$ décrit l'état interne du système.

Le système n'est connu qu'à travers quelques mesures effectuées au cours du temps :

$$\mathcal{X} = (X_0, X_1, \dots, X_M)$$

$$G = (G_0, G_1, \dots, G_M) \text{ et } P = (P_0, P_1, \dots, P_M).$$

Le bloc de modélisation est avantageusement un réseau de neurones adapté pour reproduire un modèle de la forme :

$$x_{i+1} = h_{\hat{\Gamma}, \hat{W}}(x_i, p_i) + g_i, \quad i \geq 0$$

$$x_0 = C_X(X_0)) \quad (17)$$

où :

- $x_i$ est une compression de $X_i$ par le bloc de compression $x_i = C_x(X_i)$
- $h_{\hat{\Gamma}, \hat{W}}$ est la fonction calculée par le bloc de modélisation, $\hat{\Gamma}$ et $\hat{W}$ sont respectivement la topologie et la matrice des poids de connexions du bloc de modélisation, et
- $p_k$ et $g_k$ sont les données représentatives de l'excitation et de l'état interne du système sur lesquelles est mis en œuvre le bloc de modélisation.

Dans un mode de réalisation, représenté schématiquement en figure 6a, le nombre de paramètres pour l'état interne $P_i$ et le nombre d'excitation $G_i$ est faible, par exemple inférieur à la taille des $x_i$, alors on peut prendre $p_i = P_i$ et $g_i = G_i$.

La détermination de $h_{\hat{\Gamma}, \hat{W}}$ se fait alors par la résolution du problème d'optimisation suivant :

$$\min_{\hat{\Gamma}, \hat{W}} \sum_{i=0}^{M} \left\| h_{\hat{\Gamma}, \hat{W}}(x_i, p_i) + g_i - x_{i+1} \right\|^2 \quad (18)$$

La minimisation par rapport à $\hat{\Gamma}$ est avantageusement effectuée par l'étape d'optimisation topologique 200 décrite ci-avant, et pour $\hat{\Gamma}$ fixé, on utilise une technique de Gauss-Newton zéro mémoire pour estimer W.

Sinon, dans le cas où le nombre de paramètres pour P et G est plus élevé, on comprime également ces paramètres pour obtenir

$$p_i = C_P(P_i)$$

$$g_i = C_G(G_i)$$

Où :

- $C_p$ est un opérateur de compression, éventuellement linéaire, adapté pour compresser des données $P_i$ en des données $p_i$, et
- $C_G$ est un opérateur de compression, éventuellement linéaire, adapté pour compresser des données $G_i$ en des données $g_i$ de taille égale à celle des données $x_i$.

Il s'agit de compression induite par celle des $X_i$. Même si les $P_i$ et $G_i$ ne se prêtent pas facilement à une compression, leur effet sur le système dynamique est compressible. La figure 6b montre que la compression des $X_i$ induit une compression sur les excitations $G_i$. En effet, les $X_i$ étant issus de l'intégration d'une équation aux différences, ils sont plus réguliers que les excitations $P_i$ et $G_i$. De ce fait, leur effet sur le modèle est compressible.

Ce mode de réalisation est représenté schématiquement sur la figure 6b. Dans ce cas la détermination de $h_{\hat{\Gamma},\hat{W}}$ se fait par la résolution du problème d'optimisation suivant :

$$\min_{\hat{\Gamma},\hat{W},C_P,C_G} \quad \sum_{i=0}^{M} \left\| h_{\hat{\Gamma},\hat{W}}(x_i,p_i) + g_i - x_{i+1} \right\|^2 \qquad (19)$$

La minimisation par rapport à $\hat{\Gamma}$ est effectuée par l'étape d'optimisation topologique 200 décrite ci-avant, et pour $\hat{\Gamma}$ fixé, on utilise une technique de Gauss-Newton zéro mémoire pour estimer W, $C_P$ et $C_G$.

Dans ce procédé, la boucle de récursion ne se fait pas dans l'espace réel des Xi mais dans l'espace des données compressées. Cette compression réduit le bruit sur les données et assure une meilleure stabilité du modèle dynamique, tout en réduisant les temps de calcul dans les phases d'apprentissage et de simulation. Quelle que soit la méthode utilisée pour l'initialisation de W et éventuellement pour sa mise à jour, le nombre de modifications topologiques à tester peut augmenter très rapidement avec la taille du réseau neuronal. Pour limiter la quantité de calculs, on peut choisir les configurations à tester au hasard et ne retenir que celle qui donne la meilleure estimation pour la réduction de l'erreur.

*Exemple*

A titre d'illustration, un exemple d'application possible mais nullement limitatif est celui de la modélisation de la fusion d'un bloc de sodium solide.

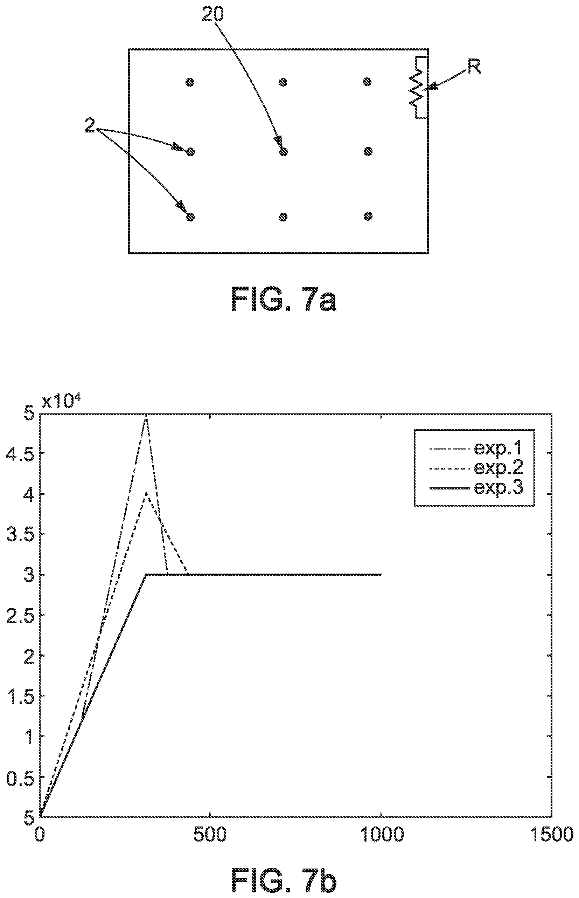

En référence à la figure 7a, on considère un récipient carré de faible hauteur qui contient du sodium à l'état solide. La figure 7a est une vue de dessus de ce récipient, qui est chauffé par une résistance électrique positionnée dans un coin du récipient dans le but de faire fondre le sodium.

Trois expériences sont réalisées. Lors de chaque expérience, la résistance est alimentée par respectivement l'un des trois profils de puissance représentés à la figure 7b. Sur cette figure, on a représenté en abscisse le temps en secondes et en ordonnée la puissance délivrée à la résistance en Watts.

La réponse de ce système est représentée par 9 capteurs 2 de température, qui fournissent uniquement la valeur 0 si la température ne dépasse pas le seuil de fusion du sodium, et 1 si cette valeur est dépassée.

Si l'on note $z_i$ le vecteur formé par les 9 mesures à un instant i, alors $X_i$ représente l'état du système aux instants successifs i et i-1 : $X_i = \begin{pmatrix} z_i \\ z_{i-1} \\ 1 \end{pmatrix}$.

On établit un « jumeau numérique » de ce système dynamique à partir de données mesurées lors de la première expérience avec le premier profil de puissance, et conformément au procédé de simulation de système dynamique précédemment décrit en effectuant d'abord une compression de $X_i$.

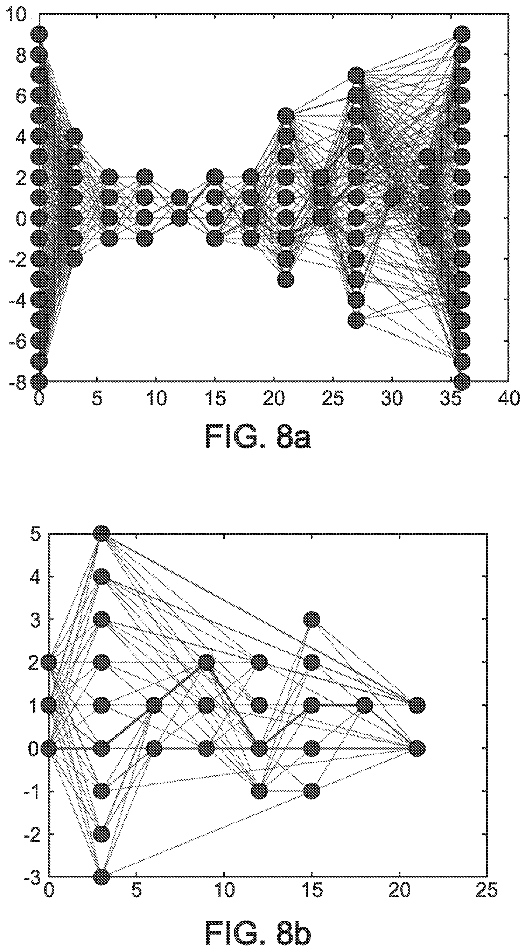

La compression donne lieu à un réseau neuronal comprenant 18 entrées (deux pour chacun des neufs capteurs) et 18 sorties. En référence à la figure 8a, qui représente un réseau neuronal de compression puis décompression de $X_i$, on constate que la compression permet de représenter chaque $X_i$ par seulement deux coefficients.

On insère ensuite entre le bloc de compression et le bloc de décompression un bloc de modélisation dynamique sous la forme d'un réseau neuronal récurrent dont le motif est représenté sur la figure 8b. La troisième entrée de ce réseau (au niveau de l'ordonnée 2) correspond à la puissance injectée dans la résistance. Sur la figure 8b, l'épaisseur de chaque connexion représente son intensité, c'est-à-dire qu'elle est représentative en relatif du poids de la connexion. On peut constater que l'excitation joue un rôle important. Pour améliorer la lisibilité des figures 8a et 8b, nous n'avons pas représenté le biais, qui est connecté à pratiquement tous les nœuds du réseau.

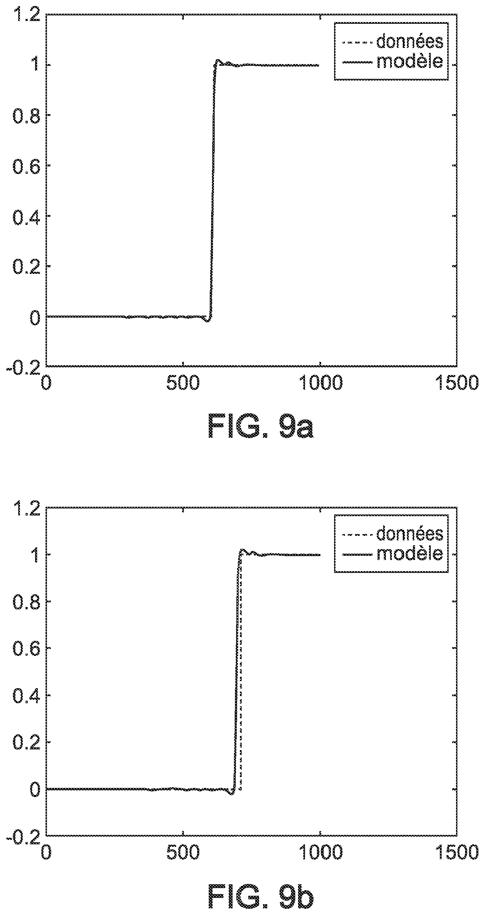

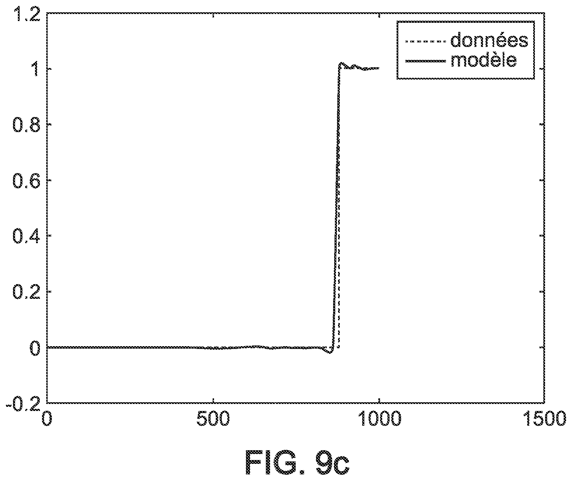

En référence aux figures 9a à 9c, on a représenté une comparaison entre les données réelles (données en traits pleins) et les données de prédiction du modèle (données en traits pointillés) ainsi construit, pour un capteur central 20 du récipient et pour chacune des trois expériences : la figure 9a correspond à l'expérience 1, la figure 9b correspond à l'expérience 2 et la figure 9c correspond à l'expérience 3. En abscisse est représenté le temps écoulé en secondes, et en ordonnée est représentée la réponse du capteur dont on rappelle qu'elle ne prend comme valeurs que 0 pour du sodium solide et 1 pour du sodium liquide.

On peut remarquer à travers ces figures que la position du front de liquéfaction du sodium dépend de manière significative de l'excitation, et que le modèle construit arrive bien à prédire cette position dans les cas de validation, qui sont ceux des figures 9b et 9c.

Annexe

La dérivée de la somme étant égale à la somme des dérivées, on établit le résultat pour une seule donnée d'apprentissage : M1 = 1.

$$\mathcal{L}(\Gamma, \mathrm{W}, \mathbf{X}, \Lambda) = \left\| 0\ \mathbf{X}^{nc} - Y \right\|^2 + \sum_{i=1}^{nc} \Lambda_i^T (X^i - f_{SI}(W_{i-1} * \mathbf{X}^{i-1}))$$

$$\partial_{X^i} \mathcal{L}(\Gamma, \mathrm{W}, \mathbf{X}, \Lambda). \phi = 0 \quad \forall\ \phi.$$

Cela donne pour i = nc : $2(0\ \mathbf{X}^{nc} - Y, O\ \phi) + tr(\Lambda_{nc}^T \phi)$, $\forall\ \phi$,

Ici (.,.) désigne le produit scalaire dans $\mathfrak{R}^{no}$.

Il en découle $\Lambda_{nc} = 2(0\ \boldsymbol{X}^{nc} - Y)^T 0$.

Et on obtient pour $i = nc - 1, nc - 2, ..., 0$ $\Lambda_i^T \phi - \sum_{j>i} \Lambda_j^T \left( f'_{SI}(W_{j-1}^I * X^i).* (W_{j-1}^I * \phi) \right) = 0, \ \forall\ \phi$,

où $W_j^I$ représente la sous-matrice de $W_j$ qui agit sur les composantes de $X^i$ La notation .* désigne le produit composante par composante de deux matrices de même taille.

En faisant parcourir à $\Phi$ les éléments de la base canonique de $\mathfrak{R}^{n_i}$, on obtient $\Lambda_i^T = \sum_{j>i} \Lambda_j^T ((f'_{SI}(W_{j-1}^I * X^i) * u).* W_{j-1}^I)$, où $u = (1,1,...,1)$ est un vecteur ligne ayant $n_i$ éléments. En effectuant une transposition, on obtient : $\Lambda_i = \sum_{j>i}(u^T f'_{SI}(W_{j-1}^I * X^i)^T.* (W_{j-1}^I)^T)\Lambda_j$, pour $i = nc$-1,...,0.

Que l'on peut écrire également sous la forme $\Lambda_i = \sum_{j>i}(diag(f'_{SI}(W_{j-1}^I * X^i)) * (W_{j-1}^I)^T)\Lambda_j$, pour $i = nc$ - 1, ... , 0, où diag(x) désigne la matrice diagonale dont les termes diagonaux sont formés par les éléments du vecteur x.

**Revendications**

**1.** Procédé de compression de données, mis en œuvre par ordinateur, le procédé comprenant la construction d'un

réseau de neurones comprenant un bloc de compression recevant en entrée une donnée X et étant adapté pour comprimer la donnée d'entrée X, et un bloc de décompression générant en sortie la donnée X,
et l'application, à au moins une donnée représentative de l'état d'un système réel et acquise par un capteur (12), du bloc de compression du réseau de neurones construit,
dans lequel chaque bloc du réseau de neurones est à propagation avant, comprenant un ensemble de nœuds de traitement et de connexions entre les nœuds formant une topologie organisée en couches, telle que chaque couche est définie par un ensemble de nœuds calculables simultanément, et l'entrée d'un nœud de traitement d'une couche peut être connectée à la sortie d'un nœud de l'une quelconque des couches précédemment calculées,
dans lequel l'étape de construction du réseau de neurones comprend :

- une étape d'initialisation (100) d'un réseau de neurones selon une topologie initiale comprenant une couche d'entrée, au moins une couche cachée comprenant au moins un nœud, et un ensemble de nœuds de sortie,
- au moins une phase d'optimisation topologique (200) mise en œuvre sur le bloc de compression et le bloc de décompression et
- une phase d'apprentissage (300) de l'ensemble du réseau de neurones à topologie fixée,

chaque phase d'optimisation topologique (200) d'un bloc comprenant :

- au moins une phase additive comprenant la modification de la topologie du réseau par l'ajout d'au moins un nœud associé à une connexion d'entrée et une connexion de sortie du nœud, et/ou un lien de connexion entre l'entrée d'un nœud d'une couche et la sortie d'un nœud de l'une quelconque des couches précédentes, et/ou

- au moins une phase soustractive comprenant la modification de la topologie du réseau par la suppression d'au moins un nœud et/ou un lien de connexion entre deux couches, dans lequel chaque modification de topologie comprend la sélection (212) d'une modification de topologie parmi plusieurs modifications candidates, à partir d'une estimation (211) de la variation de l'erreur du réseau, calculée sur une base de données réparties en deux-sous-ensembles disjoints dont le premier constitue une base de données d'apprentissage et le deuxième forme une base de données de validation, entre chaque topologie modifiée selon une modification candidate et la topologie précédente, ladite optimisation topologique (200) étant **caractérisée en ce qu'**elle comprend :

- la mise en oeuvre d'au moins une étape additive pour faire baisser l'erreur moyenne sur les données d'apprentissage,

- la mise en oeuvre d'au moins une étape soustractive, si l'erreur sur les données d'apprentissage devient inférieure à l'erreur sur les données de validation au-delà d'une tolérance prédéterminée, et

- l'arrêt de l'optimisation topologique lorsque toute étape additive ou soustractive ne résulte plus en une diminution de l'erreur sur les données d'apprentissage et sur les données de validation.

2. Procédé selon la revendication 1, dans lequel la modification de topologie sélectionnée est celle, parmi les modifications candidates, optimisant la variation de l'erreur par rapport à la topologie précédente, et l'erreur du réseau pour une topologie donnée est définie par $J(\Gamma, W^*)$, où

    - J est une fonction d'erreur entre des sorties du réseau et un résultat cible,
    - $\Gamma$ est la topologie du réseau, et
    $W^*$ est la matrice des poids de connexion du réseau minimisant la fonction d'erreur J à topologie $\Gamma$ fixée.

3. Procédé selon l'une des revendications précédentes, dans lequel l'estimation de la variation de l'erreur du réseau entre une topologie modifiée et la topologie précédente comprend l'estimation de l'erreur du réseau selon la topologie modifiée à partir de l'opérateur de Lagrange appliqué aux poids de connexion du réseau de neurones $\mathcal{L}(\Gamma, W, \mathbf{X}, \Lambda)$ où :

    $\mathcal{L}$ est l'opérateur de Lagrange
    $\Gamma$ est la topologie du réseau,
    W est une matrice de poids de connexion du réseau,
    $\mathbf{X}=(X^0,...,X^{nc})$ représente les sorties de l'ensemble des nœuds du réseau et $X^i$ représente les sorties des cellules de la couche i, et
    $\Lambda_i$ est le multiplicateur de Lagrange associé à l'expression définissant les éléments de la couche $X^i$.

4. Procédé selon la revendication précédente, dans lequel, lors d'une phase additive, la variation de l'erreur du réseau entre une topologie candidate et la topologie précédente est estimée en calculant la quantité :

$$\mathcal{L}(\Gamma^n, W^n, \mathbf{X}, \Lambda) - J(\Gamma^{n-1}, W^{n-1*})$$

où :

    - $\Gamma^n$ est la topologie du réseau candidate à l'itération n,
    - $W^{n-1*}$ est la matrice des poids de connexion du réseau de la topologie d'itération n-1 minimisant la fonction d'erreur J pour une topographie fixée,
    - $W^n$ est une matrice des poids de connexion du réseau après la modification topologique candidate à l'itération n, ladite matrice étant initialisée avec les mêmes poids de connexion que la matrice $W^{n-1*}$ pour les connexions communes entre la topologie candidate à l'itération n et la topologie d'itération n-1, et un poids de connexion nul pour chaque lien créé lors de la phase additive, puis mise à jour par minimisation de $\mathcal{L}$ par rapport aux poids des liens créés

5. Procédé selon l'une des revendications 3 ou 4 dans lequel, lors d'une phase soustractive, la variation de l'erreur du réseau entre une topologie calculée et la topologie précédente est estimée en calculant la quantité :

$$\mathcal{L}(\Gamma^n, W^n, \boldsymbol{X}, \Lambda) - J(\Gamma^{n-1}, W^{n-1*})$$

où $W^n = W_{|\Gamma^n}^{n-1*}$ est une restriction de $W^{n-1*}$ à la topologie $\Gamma^n$.

6. Procédé selon l'une des revendications précédentes, dans lequel le réseau de neurones est adapté pour simuler un système physique régi par une équation de type Y=f(X) où X est une donnée d'entrée et Y est une réponse du système physique, et l'erreur J du réseau de neurones est définie en fonction de la topologie $\Gamma$ et de la matrice W des poids de connexion du réseau, par :

$$J(\Gamma, W) = \sum_{i=1}^{M} \left\| f_{\Gamma, W}(X_i) - Y_i \right\|^2$$

où $f_{\Gamma, W}(X_i)$ est la sortie du réseau de neurones, et $X_i$ et $Y_i$ sont respectivement des données d'entrée et de sortie engendrées par des mesures sur le système réel.

7. Procédé selon l'une des revendications précédentes, comprenant, une fois la modification de topologie sélectionnée, la détermination (213) d'une matrice des poids de connexion du réseau par une méthode de descente de l'erreur par rapport à ladite matrice.

8. Procédé mis en ouvre par ordinateur de modélisation d'un système physique, biologique, chimique ou informatique, le système étant un système dynamique régi par une équation de la forme

$$X_{i+1} = F(X_i, P_i) + G_i, \quad i \geq 0$$

où $X_i$ est une caractéristique mesurable du système physique à un instant donné, $P_i$ décrit l'état interne du système physique, et $G_i$ décrit une excitation,
le procédé comprenant :

- la construction d'un réseau de neurones comprenant un bloc de compression, un bloc de décompression, et un bloc de modélisation, respectivement en sortie du bloc de compression ou en entrée du bloc de décompression, le bloc de modélisation étant adapté pour calculer une sortie $X_{i+1}$ de la forme :

$$x_{i+1} = h_{\hat{\Gamma}, \hat{W}}(x_i, p_i) + g_i, \quad i \geq 0$$

$$x_0 = C_X(X_0)) \quad (17)$$

où :

$x_i$ est une compression de $X_i$ par le bloc de compression $x_i = C_X(X_i)$,
$h_{\hat{\Gamma}, \hat{W}}$ est la fonction calculée par le bloc de modélisation, $\hat{\Gamma}$ et $\hat{W}$ sont respectivement la topologie et la matrice des poids de connexions du bloc de modélisation, et
$p_k$ et $g_k$ sont les données représentatives de l'excitation et de l'état interne du système sur lesquelles est mis en œuvre le bloc de modélisation,

- L'acquisition de $X_i$, $P_i$ et $G_i$ mesurées sur le système par au moins un capteur (12),
- La compression par le bloc de compression de $X_i$ pour obtenir une donnée compressée $x_i$,
- L'application récurrente, un nombre k de fois, du bloc de modélisation, sur la donnée compressée $x_i$ pour obtenir au moins une donnée compressée ultérieure $x_{i+k}$, et
- La décompression de la donnée compressée ultérieure $X_{i+1}$ par le bloc de décompression pour obtenir une modélisation d'une grandeur ultérieure $X_{i+k}$,

dans lequel le réseau de neurones est à propagation avant, comprenant un ensemble de nœuds de traitement et de connexions entre les nœuds formant une topologie organisée en couches, telle que chaque couche est définie par un ensemble de nœuds calculables simultanément, et l'entrée d'un nœud de traitement d'une couche peut être connectée à la sortie d'un nœud de l'une quelconque des couches précédemment calculées,

dans lequel l'étape de construction du réseau de neurones comprend :

- une étape d'initialisation (100) d'un réseau de neurones selon une topologie initiale comprenant une couche d'entrée, au moins une couche cachée comprenant au moins un nœud, et un ensemble de nœuds de sortie,
- au moins une phase d'optimisation topologique (200) mise en œuvre sur le bloc de compression, sur le bloc de modélisation, et sur le bloc de décompression, et
- une phase d'apprentissage (300) de l'ensemble du réseau de neurones à topologie fixée,

chaque phase d'optimisation topologique (200) comprenant :

- au moins une phase additive comprenant la modification de la topologie du réseau par l'ajout d'au moins un nœud associé à une connexion d'entrée et une connexion de sortie du nœud, et/ou un lien de connexion entre l'entrée d'un nœud d'une couche et la sortie d'un nœud de l'une quelconque des couches précédentes, et/ou
- au moins une phase soustractive comprenant la modification de la topologie du réseau par la suppression d'au moins un nœud et/ou un lien de connexion entre deux couches,

dans lequel chaque modification de topologie comprend la sélection (212) d'une modification de topologie parmi plusieurs modifications candidates, à partir d'une estimation (211) de la variation de l'erreur du réseau, calculée sur une base de données réparties en deux-sous-ensembles disjoints dont le premier constitue une base de données d'apprentissage et le deuxième forme une base de données de validation, entre chaque topologie modifiée selon une modification candidate et la topologie précédente, ladite optimisation topologique (200) étant **caractérisée en ce qu'**elle comprend :

- la mise en œuvre d'au moins une étape additive pour faire baisser l'erreur moyenne sur les données d'apprentissage,
- la mise en œuvre d'au moins une étape soustractive, si l'erreur sur les données d'apprentissage devient inférieure à l'erreur sur les données de validation au-delà d'une tolérance prédéterminée, et
- l'arrêt de l'optimisation topologique lorsque toute étape additive ou soustractive ne résulte plus en une diminution de l'erreur sur les données d'apprentissage et sur les données de validation.

9. Procédé mis en œuvre par ordinateur de simulation d'un système physique, biologique, chimique ou informatique, régi par une équation de type Y=f(X) où X est une donnée d'entrée et Y est une réponse du système réel, le procédé comprenant :

- la construction d'un réseau de neurones adapté pour calculer une fonction $f_{\Gamma,W}$ telle que $Y \approx f_{\Gamma,W}(X)$, et
- l'application, à une nouvelle donnée d'entrée $X_i$ représentative d'une grandeur physique du système et mesurée sur celui-ci par au moins un capteur (12), du réseau de neurones, pour en déduire une simulation de réponse $Y_i$ du système,

dans lequel le réseau de neurones est à propagation avant, comprenant un ensemble de nœuds de traitement et de connexions entre les nœuds formant une topologie organisée en couches, telle que chaque couche est définie par un ensemble de nœuds calculables simultanément, et l'entrée d'un nœud de traitement d'une couche peut être connectée à la sortie d'un nœud de l'une quelconque des couches précédemment calculées,

dans lequel l'étape de construction du réseau de neurones comprend :

- une étape d'initialisation (100) d'un réseau de neurones selon une topologie initiale comprenant une couche d'entrée, au moins une couche cachée comprenant au moins un nœud, et un ensemble de nœuds de sortie,
- au moins une phase d'optimisation topologique (200), et
- une phase d'apprentissage (300) de l'ensemble du réseau de neurones à topologie fixée,

chaque phase d'optimisation topologique (200) comprenant :

- au moins une phase additive comprenant la modification de la topologie du réseau par l'ajout d'au moins un nœud associé à une connexion d'entrée et une connexion de sortie du nœud, et/ou un lien de connexion entre l'entrée d'un nœud d'une couche et la sortie d'un nœud de l'une quelconque des couches précédentes, et/ou

- au moins une phase soustractive comprenant la modification de la topologie du réseau par la suppression d'au moins un nœud et/ou un lien de connexion entre deux couches,

dans lequel chaque modification de topologie comprend la sélection (212) d'une modification de topologie parmi plusieurs modifications candidates, à partir d'une estimation (211) de la variation de l'erreur du réseau, calculée sur une base de données réparties en deux-sous-ensembles disjoints dont le premier constitue une base de données d'apprentissage et le deuxième forme une base de données de validation, entre chaque topologie modifiée selon une modification candidate et la topologie précédente, ladite optimisation topologique (200) étant **caractérisée en ce qu'**elle comprend :

- la mise en œuvre d'au moins une étape additive pour faire baisser l'erreur moyenne sur les données d'apprentissage,
- la mise en œuvre d'au moins une étape soustractive, si l'erreur sur les données d'apprentissage devient inférieure à l'erreur sur les données de validation au-delà d'une tolérance prédéterminée, et
- l'arrêt de l'optimisation topologique lorsque toute étape additive ou soustractive ne résulte plus en une diminution de l'erreur sur les données d'apprentissage et sur les données de validation.

10. Produit programme d'ordinateur, comprenant des instructions de code pour la mise en œuvre du procédé selon l'une des revendications 1 à 9, lorsqu'il est exécuté par un processeur (10).

**Patentansprüche**

1. Verfahren zur Kompression von Datensätzen, welches von einem Computer angewendet wird, das Verfahren umfassend den Aufbau eines neuronalen Netzes, welches einen Kompressionsblock, welcher an seinem Eingang einen Datensatz X empfängt und dazu eingerichtet ist, den Eingangsdatensatz X zu komprimieren, und einen Dekompressionsblock umfasst, welcher an seinem Ausgang den Datensatz X erzeugt, und die Anwendung auf wenigstens einen Datensatz, welcher für wenigstens einen Zustand eines realen System repräsentativ ist und welcher von einem Sensor (12) erfasst wird, des Kompressionsblocks des aufgebauten neuronalen Netzwerks, wobei jeder Block des neuronalen Netzwerks eine Vorwärtsausbreitung aufweist, welche eine Reihe von Verarbeitungsknoten und Verbindungen zwischen den Knoten umfasst, welche eine in Schichten organisierte Topologie bilden, sodass jede Schicht durch eine Reihe von gleichzeitig berechenbaren Knoten definiert ist, und der Eingang eines Verarbeitungsknotens einer Schicht mit dem Ausgang eines Knotens einer beliebigen der zuvor berechneten Schichten verbunden werden kann, wobei der Schritt des Aufbaus des neuronalen Netzes umfasst:

- einen Schritt zum Initialisieren (100) eines neuronalen Netzes gemäß einer Anfangstopologie umfassend eine Eingangsschicht, wenigstens eine versteckte Schicht, welche wenigstens einen Knoten umfasst, und eine Gruppe von Ausgangsknoten,
- wenigstens eine Phase zum topologischen Optimieren (200), welche auf den Kompressionsblock und den Dekompressionsblock angewendet wird, und
- eine Lernphase (300) des gesamten neuronalen Netzwerks mit fester Topologie,

wobei jede Phase der topologischen Optimierung (200) eines Blocks umfasst:

- wenigstens eine additive Phase, welche die Änderung der Netzwerktopologie durch Hinzufügen wenigstens eines Knotens umfasst, welcher mit einer Eingangsverbindung und einer Ausgangsverbindung des Knotens verbunden ist, und/oder einen Verbindungslink zwischen dem Eingang eines Knotens einer Schicht und dem Ausgang eines Knotens einer der vorhergehenden Schichten, und/oder
- wenigstens eine subtraktive Phase, welche die Änderung der Netzwerktopologie durch Entfernen wenigstens eines Knotens und/oder eines Verbindungslinks zwischen zwei Schichten umfasst, wobei jede Topologieänderung die Auswahl (212) einer Topologieänderung aus mehreren Kandidatenänderungen auf Grundlage einer Schätzung (211) der Variation des Netzwerkfehlers umfasst, welche auf Grundlage eines Datensatzes berechnet wird, welcher in zwei disjunkte Teilmengen unterteilt ist, von welchen der erste einen Lerndatensatz und der zweite einen Validierungsdatensatz bildet, zwischen jeder gemäß einer Kandidatenänderung geänderten Topologie und der vorherigen Topologie, wobei das topologische Optimieren (200) **dadurch gekennzeichnet ist, dass** es umfasst

• das Anwenden wenigstens eines additiven Schritts, um den mittleren Fehler bei den Lerndatensätzen zu verringern,
• das Anwenden wenigstens eines subtraktiven Schritts, wenn der Fehler bei den Lerndatensätzen unter einen vorbestimmten Toleranzwert gegenüber dem Fehler bei den Validierungsdatensätzen sinkt, und
• das Beenden des topologischen Optimierens, wenn kein additiver oder subtraktiver Schritt mehr zu einer Verringerung des Fehlers bei den Lerndatensätzen und den Validierungsdatensätzen führt.

2. Verfahren nach Anspruch 1, wobei die ausgewählte Topologieänderung unter den Kandidatenänderungen diejenige ist, welche die Fehlerabweichung gegenüber der vorherigen Topologie optimiert, und der Netzwerkfehler für eine bestimmte Topologie durch $J(\Gamma, W^*)$ definiert ist, wobei

• J eine Fehlerfunktion zwischen den Netzwerkausgaben und einem Zielergebnis ist,
• $\Gamma$ die Topologie des Netzwerks ist und
• $W^*$ die Matrix der Verbindungsgewichte des Netzwerks ist, welche die Fehlerfunktion J bei fester Topologie $\Gamma$ minimiert.

3. Verfahren nach einem der vorhergehenden Ansprüche, wobei die Schätzung der Veränderung des Netzwerkfehlers zwischen einer geänderten Topologie und der vorherigen Topologie die Schätzung des Netzwerkfehlers gemäß der geänderten Topologie anhand des Lagrange-Operators umfasst, welcher auf die Verbindungsgewichte des neuronalen Netzes $L(\Gamma, W, X, \Lambda)$ angewendet wird, wobei:

L der Lagrange-Operator ist,
$\Gamma$ die Netzwerktopologie ist,
W eine Matrix der Verbindungsgewichte des Netzwerks ist,
$X=(X^0, ..., X^{nc})$ die Ausgaben aller Knoten des Netzwerks darstellt und $X^i$ die Ausgaben der Zellen der Schicht i darstellt, und
$\Lambda_i$ der Lagrange-Multiplikator ist, welcher mit dem Ausdruck verbunden ist, welcher die Elemente der Schicht $X^i$ definiert.

4. Verfahren nach dem vorhergehenden Anspruch, wobei in einer additiven Phase die Änderung des Netzwerksfehlers zwischen einer Kandidatentopologie und der vorherigen Topologie durch Berechnung der Größe geschätzt wird:

$$L(\Gamma^n, W^n, X, \Lambda) - J(\Gamma^{n-1}, W^{n-1*})$$

wobei:

• $\Gamma^n$ die Kandidatennetzwerktopologie bei der Iteration n ist,
• $W^{n-1*}$ die Matrix der Verbindungsgewichte des Netzwerks der Topologie der Iteration n-1 ist, welche die Fehlerfunktion J für eine festgelegte Topografie minimiert,
• $W^n$ eine Matrix der Verbindungsgewichte des Netzwerks nach der topologischen Kandidatenänderung bei der Iteration n ist, wobei die Matrix mit denselben Verbindungsgewichten wie die Matrix $W^{n-1*}$ für die gemeinsamen Verbindungen zwischen der Kandidatentopologie bei der Iteration n und der Topologie der Iteration n-1 initialisiert wird, und einem Verbindungsgewicht von Null für jeden Link, welcher während der additiven Phase erstellt worden ist, und dann durch Minimierung von L in Bezug auf die Gewichte der erstellten Links aktualisiert wird.

5. Verfahren nach einem der Ansprüche 3 oder 4, wobei in einer subtraktiven Phase die Änderung des Netzwerkfehlers zwischen einer berechneten Topologie und der vorherigen Topologie durch Berechnung der Größe geschätzt wird:

$$L(\Gamma^n, W^n, X, \Lambda) - J(\Gamma^{n-1}, W^{n-1*}),$$

wobei $W = W_{|\Gamma^n}^{n-1*}$ eine Beschränkung von $W^{n-1*}$ auf die Topologie $\Gamma^n$ ist.

6. Verfahren nach einem der vorhergehenden Ansprüche, wobei das neuronale Netz dazu eingerichtet ist, ein physikalisches System zu simulieren, welches durch eine Gleichung von dem Typ Y=f(X) geregelt wird, wobei X eine Eingangsgröße und Y eine Antwort des physikalischen Systems ist, und der Fehler J des neuronalen Netzes in Abhängigkeit von der Topologie Γ und der Matrix W der Verbindungsgewichte des Netzes definiert ist durch

$$J(\Gamma, W) = \sum_{i=1}^{M} \left\| f_{\Gamma, W}(x_i) - Y_1 \right\|^2$$

wobei $f_{\Gamma,W}(x_i)$ die Ausgabe des neuronalen Netzes ist und $X_i$ und $Y_i$ jeweils Eingangs- und Ausgangsdatensätze sind, welche durch Messungen an dem realen System erzeugt werden.

7. Verfahren nach einem der vorhergehenden Ansprüche, umfassend, nachdem die Topologieänderung ausgewählt worden ist, die Bestimmung (213) einer Matrix der Verbindungsgewichte des Netzwerks durch ein Verfahren des Fehlerabstiegs in Bezug auf die Matrix.

8. Computerimplementiertes Verfahren zum Modellieren eines physikalischen, biologischen, chemischen oder informatischen Systems, wobei das System ein dynamisches System ist, welches geregelt wird durch eine Gleichung der Form

$$X_{i+1} = F(X_1, P_1) + G_i, i \geq 0,$$

wobei $X_i$ eine messbare Eigenschaft des physikalischen Systems zu einem bestimmten Zeitpunkt ist, $P_i$ den internen Zustand des physikalischen Systems beschreibt und $G_i$ eine Anregung beschreibt, das Verfahren umfassend:

• den Aufbau eines neuronalen Netzes, welches einen Kompressionsblock, einen Dekompressionsblock und einen Modellierungsblock umfasst, welche jeweils an dem Ausgang des Kompressionsblocks bzw. an dem Eingang des Dekompressionsblocks angeordnet sind, wobei der Modellierungsblock dazu eingerichtet ist, eine Ausgabe $X_{i+1}$ der nachfolgenden Form zu berechnen:

$$x_{i+1} = h_{\hat{\Gamma}, \widehat{W}}(x_i, p_i) + g_i, i \geq 0,$$

$$x_0 = C_X(X_0)) \quad (17)$$

wobei $x_i$ eine Kompression von $X_i$ durch den Kompressionsblock $X_i = C_x(X_i)$ ist, $h_{\hat{\Gamma},\hat{W}}$ die von dem Modellierungsblock berechnete Funktion ist, $\hat{\Gamma}$ und $\hat{W}$ jeweils die Topologie und die Verbindungsgewichtungsmatrix des Modellierungsblocks sind und $p_k$ und $g_k$ die Datensätze sind, welche für die Anregung und den internen Zustand des Systems repräsentativ sind, auf welche der Modellierungsblock angewendet wird,

• die Erfassung von $X_i$, $P_i$ und $G_i$, welche mit wenigstens einem Sensor (12) an dem System gemessen werden,
• die Kompression durch den Kompressionsblock $X_i$, um einen komprimierten Datensatz $x_i$ zu erhalten,
• die wiederholte Anwendung des Modellierungsblocks k-mal auf den komprimierten Datensatz xi, um wenigstens einen weiteren komprimierten Datensatz $x_{i+k}$ zu erhalten, und
• die Dekompression des nachfolgenden komprimierten Datensatzes durch den Dekompressionsblock, um eine Modellierung einer nachfolgenden Größe $X_{i+k}$ zu erhalten,

wobei das neuronale Netz ein Vorwärtsausbreitungsnetz ist, welches eine Gruppe von Verarbeitungsknoten und Verbindungen zwischen den Knoten umfasst, welche eine in Schichten organisierte Topologie bilden, sodass jede Schicht durch eine Reihe von gleichzeitig berechenbaren Knoten definiert ist, und der Eingang eines Verarbeitungsknotens einer Schicht mit dem Ausgang eines Knotens einer beliebigen der zuvor berechneten Schichten verbunden werden kann, wobei der Schritt des Aufbaus des neuronalen Netzes umfasst:

• einen Schritt zum Initialisieren (100) eines neuronalen Netzes gemäß einer Anfangstopologie umfassend eine Eingangsschicht, wenigstens eine versteckte Schicht, welche wenigstens einen Knoten umfasst, und eine Gruppe von Ausgangsknoten,
• wenigstens eine Phase zum topologischen Optimieren (200), welche auf den Kompressionsblock, den Modellierungsblock und den Dekompressionsblock angewendet wird, und
• eine Lernphase (300) des gesamten neuronalen Netzwerks mit fester Topologie,

wobei jede Phase des topologischen Optimierens (200) umfasst:

• wenigstens eine additive Phase, welche die Änderung der Netzwerktopologie durch Hinzufügen wenigstens eines Knotens umfasst, welcher mit einer Eingangsverbindung und einer Ausgangsverbindung des Knotens verbunden ist, und/oder einen Verbindungslink zwischen dem Eingang eines Knotens einer Schicht und dem Ausgang eines Knotens einer der vorhergehenden Schichten, und/oder
• wenigstens eine subtraktive Phase, welche die Änderung der Netzwerktopologie durch Entfernen wenigstens eines Knotens und/oder eines Verbindungslinks zwischen zwei Schichten umfasst, wobei jede Topologieänderung die Auswahl (212) einer Topologieänderung aus mehreren Kandidatenänderungen auf Grundlage einer Schätzung (211) der Variation des Netzwerkfehlers umfasst, welche auf Grundlage eines Datensatzes berechnet wird, welcher in zwei disjunkte Teilmengen unterteilt ist, von welchen der erste einen Lerndatensatz und der zweite einen Validierungsdatensatz bildet, zwischen jeder gemäß einer Kandidatenänderung geänderten Topologie und der vorherigen Topologie, wobei das topologische Optimieren (200) **dadurch gekennzeichnet ist, dass** es umfasst
• das Anwenden wenigstens eines additiven Schritts, um den mittleren Fehler bei den Lerndatensätzen zu verringern,
• das Anwenden wenigstens eines subtraktiven Schritts, wenn der Fehler bei den Lerndatensätzen unter einen vorbestimmten Toleranzwert gegenüber dem Fehler bei den Validierungsdatensätzen sinkt, und
• das Beenden der topologischen Optimierung, wenn kein additiver oder subtraktiver Schritt mehr zu einer Verringerung des Fehlers bei den Lerndatensätzen und den Validierungsdatensätzen führt.

9. Computerimplementiertes Verfahren zur Simulation eines physikalischen, biologischen, chemischen oder informatischen Systems, welches durch eine Gleichung von dem Typ Y=f(X) geregelt wird, wobei X eine Eingangsgröße und Y eine Antwort des realen Systems ist, das Verfahren umfassend:

• die Konstruktion eines neuronalen Netzes, welches dazu eingerichtet ist, eine Funktion $f_{\Gamma,W}$ zu berechnen, wie $Y \approx f_{\Gamma,W}(X)$, und
• die Anwendung des neuronalen Netzes auf eine neue Eingangsgröße $X_i$, welche eine physikalische Größe des Systems repräsentiert und an diesem durch wenigstens einen Sensor (12) gemessen wird, um daraus eine Simulation der Antwort $Y_i$ des Systems abzuleiten, wobei das neuronale Netzwerk ein Vorwärtsausbreitungsnetzwerk ist, welches eine Gruppe von Verarbeitungsknoten und Verbindungen zwischen den Knoten umfasst, welche eine in Schichten organisierte Topologie bilden, sodass jede Schicht durch eine Gruppe von gleichzeitig berechenbaren Knoten definiert ist, und der Eingang eines Verarbeitungsknotens einer Schicht mit dem Ausgang eines Knotens einer beliebigen der zuvor berechneten Schichten verbunden werden kann, wobei der Schritt des Aufbaus des neuronalen Netzes umfasst:
• einen Schritt zum Initialisieren (100) eines neuronalen Netzes gemäß einer Anfangstopologie umfassend eine Eingangsschicht, wenigstens eine versteckte Schicht, welche wenigstens einen Knoten umfasst, und eine Gruppe von Ausgangsknoten,
• wenigstens eine Phase zum topologischen Optimieren (200), und
• eine Lernphase (300) des gesamten neuronalen Netzwerks mit fester Topologie,

wobei jede Phase des topologischen Optimierens (200) umfasst:

• wenigstens eine additive Phase, welche die Änderung der Netzwerktopologie durch Hinzufügen wenigstens eines Knotens umfasst, welcher mit einer Eingangsverbindung und einer Ausgangsverbindung des Knotens verbunden ist, und/oder einen Verbindungslink zwischen dem Eingang eines Knotens einer Schicht und dem Ausgang eines Knotens einer der vorhergehenden Schichten, und/oder
• wenigstens eine subtraktive Phase, welche die Änderung der Netzwerktopologie durch Entfernen wenigstens eines Knotens und/oder eines Verbindungslinks zwischen zwei Schichten umfasst, wobei jede Topologieänderung die Auswahl (212) einer Topologieänderung aus mehreren Kandidatenänderungen auf Grundlage einer Schätzung (211) der Variation des Netzwerkfehlers umfasst, welche auf Grundlage eines Datensatzes berechnet wird, welcher in zwei disjunkte Teilmengen unterteilt ist, von welchen der erste einen Lerndatensatz und der zweite einen Validierungsdatensatz bildet, zwischen jeder gemäß einer Kandidatenänderung geänderten Topologie und der vorherigen Topologie, wobei das topologische Optimieren (200) **dadurch gekennzeichnet**

**ist, dass** es umfasst

• das Anwenden wenigstens eines additiven Schritts, um den mittleren Fehler bei den Lerndatensätzen zu verringern,

• das Anwenden wenigstens eines subtraktiven Schritts, wenn der Fehler bei den Lerndatensätzen unter einen vorbestimmten Toleranzwert gegenüber dem Fehler bei den Validierungsdatensätzen sinkt, und

• das Beenden des topologischen Optimierens, wenn kein additiver oder subtraktiver Schritt mehr zu einer Verringerung des Fehlers bei den Lerndatensätzen und den Validierungsdatensätzen führt.

10. Computerprogrammprodukt, umfassend Codebefehle zur Durchführung des Verfahrens nach einem der Ansprüche 1 bis 9, wenn es von einem Prozessor (10) ausgeführt wird.

**Claims**

1. Method of data compression, implemented by a computer, the method comprising the construction of a neural network comprising a compression block receiving a datum X as input and a decompression block generating the datum X as output,

and the application, to at least one datum representative of the state of a real system, of the compression block of the constructed neural network,

wherein each block of the neural network is feedforward, comprising a set of processing nodes and of connections between the nodes forming a topology organized in layers, such that each layer is defined by a set of simultaneously calculable nodes, and the input of a processing node of a layer can be connected to the output of a node of any of the previously calculated layers,

wherein the step of construction of the neural network comprises:

- a step of initialization (100) of a neural network according to an initial topology comprising an input layer, at least one hidden layer comprising at least one node, and a set of output nodes,
- at least one topological optimization phase (200), implemented on the compression black and the decompression block, and
- a learning phase (300) on the entire neural network at fixed topology,

each topological optimization phase (200) comprising:

- at least one additive phase comprising a modification of the network topology by adding at least one node and/or a connection link between the input of a node of a layer and the output of a node of any one of the preceding layers, and/or
- at least one subtractive phase comprising a modification of the network topology by removing at least one node and/or a connection link between two layers,

and wherein each topology modification comprises the selection (212) of a topology modification among several candidate modifications, based on an estimation (211) of the variation in the network error, calculated on a training databases divided into two disjoint subsets, the first constituting a training database and the second forming a validation database, between the previous topology and each topology modified according to a candidate modification,

sait topological optimization (200) being **characterized in that** it comprises:

- the implementation of at least one additive step to reduce the average error on the training data,
- the implementation of at least one subtractive step, if the error on the training data becomes less than the error on the validation data beyond a predetermined tolerance, and
- stopping the topological optimization when no additive or subtractive step results in a reduction of the error on the training data and on the validation data.

2. Method according to claim 1, wherein the selected topology modification is the one, among the candidate modifications, which optimizes the variation of the error in comparison to the previous topology, and the network error for a given topology is defined by $J(\Gamma, W^*)$, where

- J is an error function between outputs of the network and a target result,

- Γ is the topology of the network, and

W* is the matrix of connection weights of the network, minimizing the error function J at fixed topology Γ.

3. Method according to one of the preceding claims, wherein the estimation of the variation of the network error between a modified topology and the previous topology comprises the estimation of the network error according to the modified topology based on the Lagrange operator applied to the connection weights of the neural network $\mathcal{L}(\Gamma, W, X, \Lambda)$, where:

L is the Lagrange operator,
Γ is the topology of the network,
W is a matrix of connection weights of the network,
$X=(X^0,...,X^{nc})$ represents the outputs of all the nodes of the network and $X^i$ represents the outputs of the cells of layer i, and
$\Lambda_i$ is the Lagrange multiplier associated with the expression defining the elements of layer $X^i$.

4. Method according to the preceding claim, wherein, during an additive phase, the variation of the network error between a candidate topology and the previous topology is estimated by calculating the quantity:

$$\mathcal{L}(\Gamma^n, W^n, \boldsymbol{X}, \Lambda) - J(\Gamma^{n-1}, W^{n-1*})$$

were:

- $\Gamma^n$ is the topology of the candidate network in iteration n,
- $W^{n-1*}$ is the matrix of connection weights of the network for the topology of iteration n-1 minimizing the error function J for a fixed topography,
- $W^n$ is a matrix of connection weights of the network after the candidate topological modification in iteration n, said matrix being initialized with the same connection weights as matrix $W^{n-1*}$ for the connections that are common to the candidate topology at iteration n and the topology of iteration n-1, and a connection weight of zero for each link created during the additive phase, then updating by minimization of $\mathcal{L}$ with respect to the weights of the links created.

5. Method according to one of claims 3 or 4 wherein, during a subtractive phase, the variation of the network error between a calculated topology and the previous topology is estimated by calculating the quantity:

$$\mathcal{L}(\Gamma^n, W^n, \boldsymbol{X}, \Lambda) - J(\Gamma^{n-1}, W^{n-1*})$$

where $W^n = W^{n-1*}_{|\Gamma^n}$ is a restriction of $W^{n-1*}$ to topology $\Gamma^n$.

6. Method according to one of the preceding claims, wherein the neural network is adapted to simulate a physical system governed by an equation of the type Y=f(X) where X is an input datum and Y is a response of the physical system, and the error J of the neural network is defined as a function of the topology Γ and of the matrix W of connection weights of the network, by:

$$J(\Gamma, W) = \sum_{i=1}^{M} \left\| f_{\Gamma, W}(X_i) - Y_i \right\|^2$$

where $f_{\Gamma, W}(X_i)$ is the output of the neural network, and $X_i$ and $Y_i$ are respectively input and output data generated by measurements on the real system.

7. Method according to one of the preceding claims, comprising, once the topology modification has been selected, the determination (213) of a matrix of connection weights of the network by a method of descending the error with respect to said matrix.

**8.** A computer implemented method of modelling a physical, biological, chemical or computer system, the system being a dynamic system governed by an equation of the form

$$X_{i+1} = F(X_i, P_i) + G_i, \quad i \geq 0$$

where $X_i$ is a measurable characteristic of the physical system at a given time, $P_i$ describes the internal state of the physical system, and $G_i$ describes an excitation,

the method

- comprising the construction of a neural network comprising a compression block, a decompression block, a modeling block, respectively as output from the compression block or as input to the decompression block, the modeling block is suitable for calculating an output $X_{i+1}$ of the form:

$$x_{i+1} = h_{\hat{\Gamma}, \hat{W}}(x_i, p_i) + g_i, \quad i \geq 0$$

$$x_0 = C_X(X_0)) \quad (17)$$

where:

$x_i$ is a compression of $X_i$ by the compression block $x_i = C_X(X_i)$,
$h_{\hat{\Gamma}, \hat{W}}$ is the function calculated by the modeling block, $\hat{\Gamma}$ and $\hat{W}$ are respectively the topology and the matrix of connection weights of the modeling block, and
$p_k$ and $g_k$ are the data representative of the excitation and of the internal state of the system on which the modeling block is implemented,

- the acquisition of $X_i$, $P_i$ and $G_i$ measured on the system by at least one sensor (12),
- the compression by the compression block of $X_i$ to obtain a compressed datum $x_i$,
- the recurrent application, a number k of times, of a neural network modeling the dynamic physical system, on the compressed datum $x_i$ in order to obtain at least one subsequent compressed datum $X_{i+k}$, and
- the decompression of the subsequent compressed datum $x_{i+1}$ by the decompression block in order to obtain a modeling of a subsequent quantity $X_{i+k}$,

wherein the neural network is feedforward, comprising a set of processing nodes and of connections between the nodes forming a topology organized in layers, such that each layer is defined by a set of simultaneously calculable nodes, and the input of a processing node of a layer can be connected to the output of a node of any of the previously calculated layers,
wherein the step of construction of the neural network comprises:

- a step of initialization (100) of a neural network according to an initial topology comprising an input layer, at least one hidden layer comprising at least one node, and a set of output nodes,
- at least one topological optimization phase (200), implemented on the compression black and the decompression block, and
- a learning phase (300) on the entire neural network at fixed topology,

each topological optimization phase (200) comprising:

- at least one additive phase comprising a modification of the network topology by adding at least one node and/or a connection link between the input of a node of a layer and the output of a node of any one of the preceding layers, and/or
- at least one subtractive phase comprising a modification of the network topology by removing at least one node and/or a connection link between two layers,

and wherein each topology modification comprises the selection (212) of a topology modification among several candidate modifications, based on an estimation (211) of the variation in the network error, calculated on a training databases divided into two disjoint subsets, the first constituting a training database and the second forming a validation database, between the previous topology and each topology modified according to a candidate modification,

sait topological optimization (200) being **characterized in that** it comprises:

- the implementation of at least one additive step to reduce the average error on the training data,
- the implementation of at least one subtractive step, if the error on the training data becomes less than the error on the validation data beyond a predetermined tolerance, and
- stopping the topological optimization when no additive or subtractive step results in a reduction of the error on the training data and on the validation data.

9. A computer-implented method of simulation of a physical, biological, chemical or computer system, governed by an equation of type Y=f(X) where X is an input datum and Y is a response of the real system, comprising:

- the construction of a neural network suitable for calculating a function $f_{\Gamma,W}$ such that $Y \approx f_{\Gamma,W}(X)$, and
- the application, to a new input datum $X_i$ representative of a physical quantity of the system, and measured thereon by at least one sensor (12), of the neural network, in order to deduce therefrom a simulation of response $Y_i$ of the system,

wherein the neural network is feedforward, comprising a set of processing nodes and of connections between the nodes forming a topology organized in layers, such that each layer is defined by a set of simultaneously calculable nodes, and the input of a processing node of a layer can be connected to the output of a node of any of the previously calculated layers,

wherein the step of construction of the neural network comprises:

- a step of initialization (100) of a neural network according to an initial topology comprising an input layer, at least one hidden layer comprising at least one node, and a set of output nodes,
- at least one topological optimization phase (200), implemented on the compression black and the decompression block, and
- a learning phase (300) on the entire neural network at fixed topology,

each topological optimization phase (200) comprising:

- at least one additive phase comprising a modification of the network topology by adding at least one node and/or a connection link between the input of a node of a layer and the output of a node of any one of the preceding layers, and/or
- at least one subtractive phase comprising a modification of the network topology by removing at least one node and/or a connection link between two layers,

and wherein each topology modification comprises the selection (212) of a topology modification among several candidate modifications, based on an estimation (211) of the variation in the network error, calculated on a training databases divided into two disjoint subsets, the first constituting a training database and the second forming a validation database, between the previous topology and each topology modified according to a candidate modification,

sait topological optimization (200) being **characterized in that** it comprises:

- the implementation of at least one additive step to reduce the average error on the training data,
- the implementation of at least one subtractive step, if the error on the training data becomes less than the error on the validation data beyond a predetermined tolerance, and
- stopping the topological optimization when no additive or subtractive step results in a reduction of the error on the training data and on the validation data.

10. Computer program product, comprising code instructions for implementing the method according to one of claims 1 to 9, when it is executed by a processor (10).

**FIG. 1**

**FIG. 2**

**FIG. 3**

FIG. 4a

9     13     4     1     7     1     4     1

FIG. 4b

7     17     3     4     2     1

FIG. 4C

**FIG. 5**

FIG. 6a

FIG. 6b

FIG. 7a

FIG. 7b

FIG. 8a

FIG. 8b

FIG. 9a

FIG. 9b

FIG. 9c

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 9336483 B

- US 5636326 A

**Littérature non-brevet citée dans la description**

- **LECUN, YANN ; BENGIO, YOSHUA ; HINTON, GEOFFREY**. Deep learning. *Nature*, 2015, vol. 521 (7553), 436-444
- **BOTTOU, L.** Large-scale machine learning with stochastic gradient descent. *Proceedings of COMPSTAT'2010*, 2010, 177-186
- **GLAESSGEN, E.H. ; STARGEL, D**. The Digital Twin paradigm for future NASA and US Air Force vehicles. *53rd Struct. Dyn. Mater. Conf. Special Session : Digital Twin, Honolulu, Hi, US*, April 2012
- **TUEGEL, E.J. ; INGRAFFEA, A.R. ; EASON, T.G. ; SPOTTSWOOD, S.M.** Reengineering aircraft structural life prediction using a digital twin. *International Journal of Aerospace Engineering*, 2011, vol. 2011
- IMM, Informatics and Mathematical Modelling. **LOPHAVEN, S. N. ; NIELSEN, H. B. ; SØNDERGAARD, J.** DACE: a Matlab kriging toolbox. The Technical University of Denmark, 2002, vol. 2
- **BALABIN, R. M. ; LOMAKINA, E. I.** Support vector machine regression (SVR/LS-SVM)-an alternative to neural networks (ANN) for analytical chemistry? Comparison of nonlinear methods on near infrared (NIR) spectroscopy data. *Analyst*, 2011, vol. 136 (8), 1703-1712
- Neural network topology optimization.. **ATTIK, M. ; BOUGRAIN, L. ; ALEXANDRE, F.** International Conference on Artificial Neural Networks. Springer, September 2005, 53-58
- Topology optimization for artificial neural networks using differential evolution. **MINEU, N. L. ; LUDER-MIR, T. B. ; ALMEIDA, L. M.** Neural Networks (IJCNN), The 2010 International Joint Conference on. IEEE., July 2010, 1-7

- **NAZGHELICHI, T. ; AGHBASHLO, M. ; KIANMEHR, M. H.** Optimization of an artificial neural network topology using coupled response surface methodology and genetic algorithm for fluidized bed drying.. *Computers and electronics in agriculture*, 2011, vol. 75 (1), 84-91
- **CARLBERG, K. ; FARHAT, C. ; CORTIAL, J. ; AMSALLEM, D.** The GNAT method for nonlinear model reduction: effective implementation and application to computational fluid dynamics and turbulent flows.. *Journal of Computational Physics*, 2013, vol. 242, 623-647
- **CHINESTA, F. ; LADEVEZE, P. ; CUETO, E.** A short review on model order reduction based on proper generalized decomposition.. *Archives of Computational Methods in Engineering*, 2011, vol. 18 (4), 395-404
- Finding Better Topologies for Deep Convolutional Neural Networks by Evolution. **HONGLEI ZHANG et al.** ARXIV.ORG. CORNELL UNIVERSITY LIBRARY, 10 September 2018
- Orthogonal Least Squares Algorithm for Training Cascade Neural Networks. **GAO HUANG et al.** IEEE TRANSACTIONS ON CIRCUITS AND SYSTEMS I: REGULAR PAPERS. IEEE, 01 November 2012, vol. 59, 2629-2637
- **FEHRENBACH, J. ; MASMOUDI, M. ; SOUCHON, R. ; TROMPETTE, P.** Detection of small inclusions by elastography.. *Inverse problems*, 2006, vol. 22 (3), 1055
- **ROSS, I. M.** A primer on Pontryagin's principle in optimal control. Collegiate publishers, 2015, vol. 2